# EUROPEAN PATENT APPLICATION

(11) **EP 1 624 530 A1**
(43) Date of publication of application: **08.02.2006**
(21) Application number: 04727398.2
(22) Date of filing: 14.04.2004
(51) Int. Cl.: H01R 11/01, H01R 43/00, H01B 13/00, C09D 5/23

(54) **ANISOTROPIC CONDUCTIVE SHEET AND ITS MANUFACTURING METHOD, ADAPTOR DEVICE AND ITS MANUFACTURING METHOD, AND CIRCUIT DEVICE ELECTRIC TEST INSTRUMENT**

(30) Priority: 21.04.2003 JP 2003115737
(71) Applicant: JSR Corporation, Tokyo 104-0045 (JP)
(72) Inventor: KIMURA, Kiyoshi JSR MICROTECH INC., Saitama 3501236 (JP); HARA, Fujio JSR MICROTECH INC., Saitama 3501236 (JP)
(74) Representative: TBK-Patent
(86) International application number: PCT/JP2004/005303
(87) International publication number: WO 2004/095646

(57) **Abstract**

Disclosed herein are an anisotropically conductive sheet, by which necessary electrical connection to respective electrodes to be connected can be surely achieved irrespective of the arrangement pattern of such electrodes, and necessary electrical connection to respective electrodes to be connected can be surely achieved even when the electrodes to be connected are arranged at a minute pitch and a high density, and which can be produced at low cost and, production process thereof, adaptor device and production process thereof, and an electrical inspection apparatus for circuit devices, which is equipped with any of them.

The anisotropically conductive sheet of the invention is obtained by subjecting a conductive elastomer layer supported on a releasable supporting plate to laser beam machining, thereby forming conductive path-forming parts arranged in accordance with the specific pattern on the releasable supporting plate, forming a material layer for insulating part composed of a material, which will become an elastic polymeric substance by being cured, between the conductive path-forming parts and subjecting the material layer to a curing treatment, thereby forming an insulating part.

## Description

### TECHNICAL FIELD

The present invention relates to an anisotropically conductive sheet that can be suitably used in electrical inspection of circuit devices, for example, printed circuit boards or the like and a production process thereof, an adaptor device and a production process thereof, and an electrical inspection apparatus for circuit devices, which is equipped with this anisotropically conductive sheet or adaptor device.

### BACKGROUND ART

With respect to a circuit board for making up or mounting an integrated circuit device or any other electronic part, it is generally necessary to inspect electrical properties of the circuit board before the electronic part or the like is assembled or the electronic part or the like is mounted for the purpose of confirming that a wiring pattern of the circuit board has the expected performance.

As a method for performing electrical inspection of a circuit board, there has heretofore been known a method using, in combination, an inspection electrode device, in which a plurality of inspection electrodes are arranged according to positions of lattice points located vertically and laterally, and an adaptor for electrically connecting the inspection electrodes of this inspection electrode device to electrodes to be inspected of a circuit board that is an object of inspection, or the like. The adaptor used in this method is composed of a printed wiring board called a pitch-changing board.

As this adaptor, are known that having, on one surface thereof, a plurality of connecting electrodes arranged in accordance with a pattern corresponding to electrodes to be inspected of a circuit board, which is an object of inspection, and, on the other surface, a plurality of terminal electrodes arranged at positions of lattice points of the same pitch as inspection electrodes of an inspection electrode device, and that having, on one surface thereof, plural pairs of connecting electrodes each composed of a connecting electrode for current supply and a connecting electrode for voltage measurement and arranged in accordance with a pattern corresponding to electrodes to be inspected of a circuit board, which is an object of inspection, and, on the other surface, a plurality of terminal electrodes arranged at positions of lattice points of the same pitch as inspection electrodes of an inspection electrode device, and the like. The former adaptor is used in, for example, an open short-circuit test of each circuit in a circuit board, and the latter adaptor is used in an electric resistance-measuring test of each circuit in a circuit board.

In order to achieve stable electrical connection of the circuit board, which is the object of inspection, to the adaptor in the electrical inspection of the circuit board, it is generally conducted to cause an anisotropically conductive elastomer sheet to intervene between the circuit board, which is the object of inspection, and the adaptor.

This anisotropically conductive elastomer sheet is a sheet exhibiting conductivity only in its thickness-wise direction or having a great number of pressure-sensitive conductive conductor parts exhibiting conductivity only in the thickness-wise direction when they are pressurized.

As such anisotropically conductive elastomer sheets, there have heretofore been known those of various structures, and typical examples thereof include those (see, for example, the following Prior Art. 1) obtained by uniformly dispersing metal particles in an elastomer, those (see, for example, the following Prior Art. 2) obtained by unevenly distributing particles of a conductive magnetic metal in an elastomer, thereby forming a great number of conductive path-forming part each extending in a thickness-wise direction thereof and insulating part mutually insulating them and those (see, for example, the following Prior Art. 3) obtained by defining a difference in level between the surface of each conductive path-forming part and an insulating part.

For a circuit board having electrodes to be inspection having a small arrangement pitch, an anisotropically conductive elastomer sheet, in which conductive path-forming parts have been formed in accordance with a pattern corresponding to a pattern of the electrodes to be inspected of the circuit board, is preferred from the viewpoint of achieving high reliability on connection.

However, such an anisotropically conductive elastomer sheet itself is produced as a single product and handled by itself. It is accordingly necessary to hold and fix it in a specific positional relation to the adaptor and circuit board in an electrically connecting operation.

However, the means for achieving the electrical connection of the circuit board making good use of the independent anisotropically conductive elastomer sheet involves a problem that difficulties are encountered upon the positioning, and the holding and fixing of the anisotropically conductive elastomer sheet as the arrangement pitch (hereinafter referred to as "electrode pitch") of the electrodes to be inspected in the circuit board, which is the object of inspection, namely, the center distance between electrodes to be inspected adjoining each other becomes smaller.

When the circuit board and anisotropically conductive elastomer sheet are subjected to thermal hysteresis by temperature change even if the desired positioning, and holding and fixing has been realized once, a problem that the electrically connected state is changed, and the stably connected state is not retained arises because the degree of stress by thermal expansion and thermal shrinkage becomes greatly different between a material forming the circuit board which is the object of inspection and a material forming the anisotropically conductive elastomer sheet.

In order to solve the above-described problems, there has heretofore been proposed an adaptor device composed of an adaptor body having, on its front surface, connecting electrodes arranged in accordance with a pattern corresponding to electrodes to be inspected in a circuit board, which is an object of inspection, and, on its back surface, terminal electrodes arranged in accordance with positions of lattice points, and an anisotropically conductive elastomer sheet integrally provided on the front surface of the adaptor body (see, for example, the following Prior Art. 4 and Prior Art. 5).

In the production of such an adaptor device, the anisotropically conductive elastomer sheet is formed, for example, in the following manner.

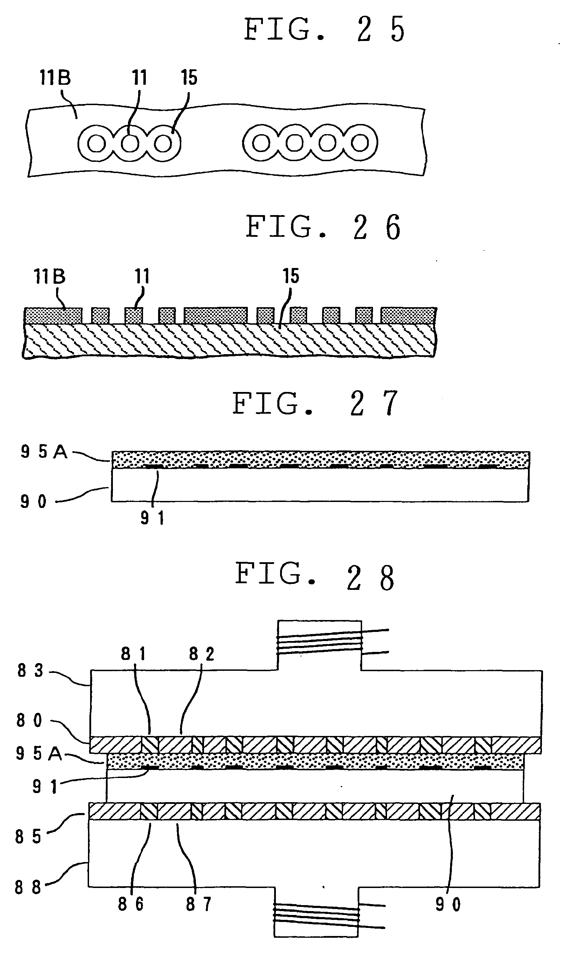

As illustrated in Fig. 27, a material layer 95A for anisotropically conductive elastomer is first formed by applying a material for anisotropically conductive elastomer with conductive magnetic substance particles dispersed in a polymeric substance-forming material, which will become an elastic polymeric substance by being cured, on to a front surface (upper surface in Fig. 27) of an adaptor body 90, on which connecting electrodes 91 have been formed, by, for example, screen printing.

As illustrated in Fig. 28, one template (hereinafter referred to as "top force") 80, in which ferromagnetic substance parts 81 are arranged in accordance with the same pattern as electrodes to be inspected of, for example, a circuit board, which is an object of inspection, and non-magnetic substance parts 82 are arranged at other portions than the ferromagnetic substance parts 81, and the other template (hereinafter referred to as "bottom force") 85, in which ferromagnetic substance parts 86 are arranged in accordance with a pattern antipodal to the electrodes to be inspected of the circuit board, which is the object of inspection, and non-magnetic substance parts 87 are arranged at other portions than the ferromagnetic substance parts 86 are used to arrange the adaptor body 90, on which the material layer 95A for anisotropically conductive elastomer has been formed, between the top force 80 and the bottom force 85 in such a manner that the connecting electrodes 91 are located between the ferromagnetic substance parts 81 of the top force 80 and their corresponding ferromagnetic substance parts 86 of the bottom force 85, and a pair of electromagnets 83 and 88 are arranged on an upper surface of the top force 80 and a lower surface of the bottom force 85, respectively.

The electromagnets 83, 88 are operated, whereby a parallel magnetic field is applied in a direction from the ferromagnetic substance parts 81 of the top force 80 toward their corresponding ferromagnetic substance parts 86 of the bottom force 85. At this time, since the ferromagnetic substance parts 81 of the top force 80 and the ferromagnetic substance parts 86 of the bottom force 85 act as magnetic poles, a magnetic field having higher intensity is applied to regions between the ferromagnetic substance parts 81 of the top force 80 and their corresponding ferromagnetic substance parts 86 of the bottom force 85 than the other regions. As a result, in the material layer 95A for anisotropically conductive elastomer, the conductive magnetic substance particles dispersed in the material layer 95A for anisotropically conductive elastomer are moved toward portions located between the ferromagnetic substance parts 81 of the top force 80 and their corresponding ferromagnetic substance parts 86 of the bottom force 85, i.e., portions located on the connecting electrodes 91 of the adaptor body 90 to be gathered at such portions and oriented so as to align in the thickness-wise direction of the material layer for anisotropically conductive elastomer.

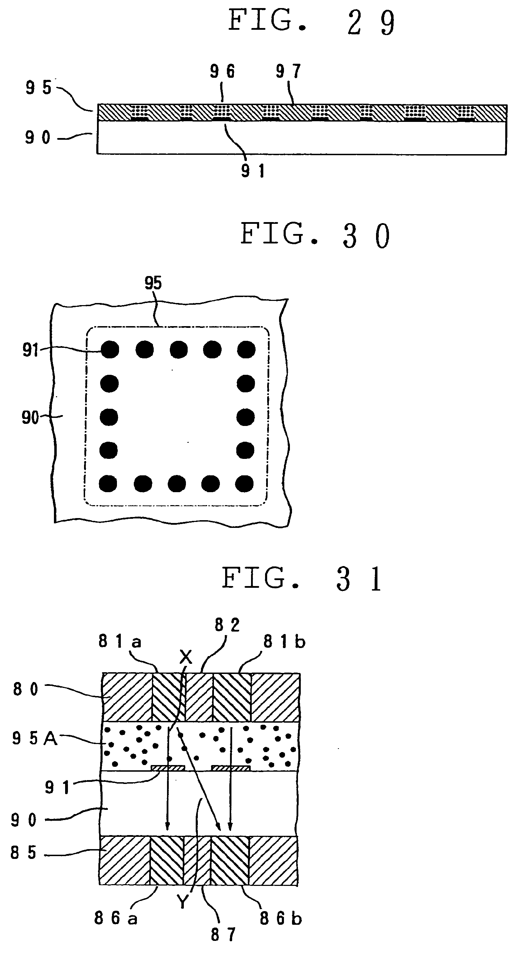

In this state, the material layer 95A for anisotropically conductive elastomer is subjected to a curing treatment by, for example, heating, whereby an anisotropically conductive elastomer sheet 95 composed of a great number of conductive path-forming parts 96 each extending in a thickness-wise direction thereof and an insulating part 97 mutually insulating them is formed integrally on the front surface of the adaptor body 90 in a state that the conductive path-forming parts 96 have been arranged on their corresponding connecting electrodes 91 as illustrated in Fig. 29, and an adaptor device is thus produced.

According to such an adaptor device, a positioning operation of the anisotropically conductive elastomer sheet is unnecessary, and a good electrically connected state is stably retained even by environmental changes such as thermal hysteresis by temperature change in an electrical inspection of a circuit board. Accordingly, high reliability on connection is achieved.

However, the adaptor device described above involves the following problems.

As a circuit board for making up or mounting an electronic part, is known that the electrodes of which are arranged in the form of a frame along, for example, 4 sides of a rectangle. In order to conduct electrical inspection for such a circuit board, it is necessary to use an adaptor device having an adaptor body 90 that the connecting electrodes 91 of which are arranged in the form of a frame along 4 sides of a rectangle as illustrated in Fig. 30. In such an adaptor device, the anisotropically conductive elastomer sheet 95 is provided in, for example, a rectangular region including the connecting electrodes 91 on the front surface of the adaptor body 90 as indicated by an alternate long and short dash line in Fig. 30.

Since all the central portion of such an anisotropically conductive elastomer sheet 95 becomes an insulating part, however, a moving distance of conductive particles present in the central portion of the material layer 95A for anisotropically conductive elastomer becomes extremely long in the formation of the anisotropically conductive elastomer sheet 95. As a result, it is difficult to surely gather the conductive particles at portions to become conductive parts. Therefore, the conductive particles are not filled in a necessary amount in the resulting conductive path-forming parts 96, and a considerable amount of the conductive particles remain in the insulating part 97, so that an expected anisotropically conductive elastomer layer cannot be formed with certainty.

On the other hand, there is currently a tendency to further advancing in shifting to higher-density integration that the arrangement pitch of the electrodes, i.e., the center distance between adjacent electrodes becomes small by the increase of the number of electrodes along a shifting to higher functionality and higher capacitance in an integrated circuit device. When electrical inspection is conducted on a circuit board for making up or mounting such an integrated circuit device, it is accordingly necessary to use an adaptor device that the connecting electrodes of which are arranged at a small pitch and a high density.

When an anisotropically conductive elastomer sheet 95 is formed on a front surface of an adaptor body 90 in the production of such an adaptor device, however, it is naturally necessary to use a top force 80 and a bottom force 85, in which ferromagnetic substance parts 81 and 86 are arranged at an extremely small pitch, respectively.

When the anisotropically conductive elastomer sheet 95 is formed in the above-described manner using such top force 80 and bottom force 85, however, a clearance between a ferromagnetic substance part 81a or 86a and a ferromagnetic substance part 81b or 86b adjoining this part in each of the top force 80 and the bottom force 85 becomes small, and a space between the top force 80 and the bottom force 85 becomes considerably great due to the thickness of the adaptor body 90 existing between them, so that a magnetic field is applied in not only a direction (indicated by an arrow X) from the ferromagnetic substance part 81a of the top force 80 toward its corresponding ferromagnetic substance part 86a of the bottom force 85, but also, for example, a direction (indicated by an arrow Y) from the ferromagnetic substance part 81a of the top force 80 toward the ferromagnetic substance part 86b adjacent to its corresponding ferromagnetic substance part 86a of the bottom force 85 as illustrated in Fig. 31. It is thus difficult to gather the conductive magnetic substance particles in the material layer 95A for anisotropically conductive elastomer at a portion located between the ferromagnetic substance part 81a of the top force 80 and its corresponding ferromagnetic substance part 86a of the bottom force 85, and so the conductive magnetic substance particles are also gathered at a portion located between the ferromagnetic substance part 81a of the top force 80 and the ferromagnetic substance part 86b of the bottom force 85. In addition, it is difficult to sufficiently orient the conductive magnetic substance particles in a thickness-wise direction of the material layer 95A for anisotropically conductive elastomer. As a result, anisotropically conductive elastomer sheet having the expected conductive parts and insulating part can not be obtained.

Further, 2 templates of the top force 80 and bottom force 85 are required for the formation of the anisotropically conductive elastomer sheet as described above. Since these templates are individually produced according to the intended adaptor device, and a production process thereof is complicated, the production cost of the adaptor device is extremely expensive, which in its turn, incurs increase in the inspection cost of circuit devices.

As the adaptor device, there has also been proposed that, in which conductive path-forming parts independent of each other are formed on respective connecting electrodes of an adaptor body by forming a conductive elastomer layer on a front surface of the adaptor body and then subjecting the conductive elastomer layer to laser beam machining to remove a part thereof (see, for example, the following Prior Art. 6).

According to such an adaptor device, necessary insulating property between adjoining conductive path-forming parts is surely achieved because each of the conductive path-forming parts are formed in a state independent of each other.

In this adaptor device, however, each of the conductive path-forming parts is supported by only the connecting electrode of the adaptor body, so that the adaptor device involves a problem that the conductive path-forming parts are liable to fall off, and so the durability of the adaptor device becomes low.

It also involves a problem that the adaptor body may possibly be damaged by the laser beam machining upon the formation of the conductive path-forming parts.
Prior Art. 1: Japanese Patent Application Laid-Open No. 93393/1976;
Prior Art. 2: Japanese Patent Application Laid-Open No. 147772/1978;
Prior Art. 3: Japanese Patent Application Laid-Open No. 250906/1986;
Prior Art. 4: Japanese Patent Application Laid-Open No. 151564/1992;
Prior Art. 5: Japanese Patent Application Laid-Open No. 82531/1994;
Patent Art. 6: Japanese Patent Application Laid-Open No. 229270/1998.

### DISCLOSURE OF THE INVENTION

The present invention has been made on the basis of the foregoing circumstances and has as its first object the provision of an anisotropically conductive sheet, by which necessary electrical connection to respective electrodes to be connected can be surely achieved irrespective of the arrangement pattern of such electrodes, and necessary electrical connection to respective electrodes to be connected can be surely achieved even when the electrodes are arranged at a minute pitch and a high density, and which can be produced at low cost, and a production process thereof.

A second object of the present invention is to provide an adaptor device, by which necessary electrical connection to a circuit device that is an object of inspection can be surely achieved irrespective of the arrangement pattern of electrodes to be inspected of the circuit device, and necessary electrical connection to a circuit device that is an object of inspection can be surely achieved even when electrodes to be inspected of the circuit device are arranged at a minute pitch and a high density, and which can be produced at low cost and is high in durability, and a production process thereof.

A third object of the present invention is to provide an electrical inspection apparatus, by which necessary electrical inspection on a circuit device that is an object of inspection can be surely performed irrespective of the arrangement pattern of electrodes to be inspected of the circuit device, and necessary electrical inspection on a circuit device that is an object of inspection can be surely performed even when electrodes to be inspected of the circuit device are arranged at a minute pitch and a high density.

According to the present invention, there is provided a process for producing an anisotropically conductive sheet formed with a plurality of conductive path-forming parts arranged in accordance with a specific pattern 1 each extending in a thickness-wise direction of the sheet and mutually insulated by an insulating part, which comprises the steps of
subjecting a conductive elastomer layer supported on a releasable supporting plate to laser beam machining, thereby forming the conductive path-forming parts arranged in accordance with the specific pattern on the releasable supporting plate, forming a material layer for insulating part composed of a material, which will become an elastic polymeric substance by being cured, between the conductive path-forming parts and subjecting the material layer to a curing treatment, thereby forming the insulating part.

In the process according to the present invention for producing the anisotropically conductive sheet, the laser beam machining may preferably be conducted by carbon dioxide gas laser.

It may also be preferable that the conductive path-forming parts arranged in accordance with the specific pattern be formed by forming metal masks on the surface of the conductive elastomer layer in accordance with the specific pattern, and then subjecting the conductive elastomer layer to the laser beam machining.

In such a production process of the anisotropically conductive sheet, the metal masks may preferably be formed by subjecting the surface of the conductive elastomer layer to a plating treatment.

The metal masks may also preferably be formed by forming a metallic thin layer on the surface of the conductive elastomer layer, forming a resist layer, in which openings have been formed in accordance with the specific pattern, on the surface of the metallic thin layer and subjecting the surfaces of portions exposed through the openings of the resist layer in the metallic thin layer to the plating treatment.

In the process according to the present invention for producing the anisotropically conductive sheet, the conductive elastomer layer may preferably be such that conductive particles exhibiting magnetism are dispersed in an insulating elastic polymeric substance in a state oriented so as to align in the thickness-wise direction.

In such a production process of the anisotropically conductive sheet, the conductive elastomer layer may preferably be formed by forming a material layer for conductive elastomer with the conductive particles exhibiting magnetism contained in a liquid elastomer material, which will become an elastic polymeric substance by being cured, on the releasable supporting plate, applying a magnetic field to the material layer for conductive elastomer in the thickness-wise direction thereof and subjecting the material layer for conductive elastomer to a curing treatment.

According to the present invention, there is provided an anisotropically conductive sheet obtained by the above-described process for producing the anisotropically conductive sheet.

According to the present invention, there is provided a process for producing an adaptor device composed of an adaptor body having, on its front surface, a connecting electrode region, in which a plurality of connecting electrodes have been formed in accordance with a pattern corresponding to electrodes to be inspected in a circuit device to be inspected, and an anisotropically conductive sheet integrally provided on the connecting electrode region of the adaptor body and composed of a plurality of conductive path-forming parts located on the respective surfaces of the connecting electrodes and extending in a thickness-wise direction thereof, and insulating part mutually insulating these conductive path-forming part, which comprises the steps of
subjecting a conductive elastomer layer, which is supported on a releasable supporting plate and is such that conductive particles exhibiting magnetism are dispersed in an elastic polymeric substance in a state oriented so as to align in the thickness-wise direction, to laser beam machining, thereby forming the conductive path-forming parts arranged in accordance with a specific pattern related to the connecting electrodes of the adaptor body on the releasable supporting plate,
superimposing the releasable supporting plate, on which the conductive path-forming parts have been formed, on the adaptor body, in which a material layer for insulating part composed of a material, which will become an elastic polymeric substance by being cured, has been formed on the connecting electrode region, thereby bringing each of the connecting electrodes in the connecting electrode region of the adaptor body into contact with its corresponding conductive path-forming part, and subjecting the material layer for insulating part to a curing treatment in this state, thereby forming the insulating part.

According to the present invention, there is provided a process for producing an adaptor device composed of an adaptor body having, on its front surface, a connecting electrode region, in which plural pairs of connecting electrodes each composed of 2 connecting electrodes for current supply and for voltage measurement have been formed in accordance with a pattern corresponding to electrodes to be inspected in a circuit device to be inspected, and an anisotropically conductive sheet integrally provided on the connecting electrode region of the adaptor body and composed of a plurality of conductive path-forming parts located on the respective surfaces of the connecting electrodes and extending in a thickness-wise direction thereof, and insulating part mutually insulating these conductive path-forming parts, which comprises the steps of
subjecting a conductive elastomer layer, which is supported on a releasable supporting plate and is such that conductive particles exhibiting magnetism are dispersed in an elastic polymeric substance in a state oriented so as to align in the thickness-wise direction, to laser beam machining, thereby forming the conductive path-forming parts arranged in accordance with a specific pattern related to the connecting electrodes of the adaptor body on the releasable supporting plate,
superimposing the releasable supporting plate, on which the conductive path-forming parts have been formed, on the adaptor body, in which a material layer for insulating part composed of a material, which will become an elastic polymeric substance by being cured, has been formed on the connecting electrode region, thereby bringing each of the connecting electrodes in the connecting electrode region of the adaptor body into contact with its corresponding conductive path-forming part, and subjecting the material layer for insulating part to a curing treatment in this state, thereby forming the insulating part.

In the process according to the present invention for producing the adaptor device, the laser beam machining may preferably be conducted by carbon dioxide gas laser.

It may also be preferable that the conductive path-forming parts arranged in accordance with the specific pattern be formed by forming metal masks on the surface of the conductive elastomer layer in accordance with the specific pattern, and then subjecting the conductive elastomer layer to the laser beam machining.

In such a production process of the adaptor device, the metal masks may preferably be formed by subjecting the surface of the conductive elastomer layer to a plating treatment.

The metal masks may also preferably be formed by forming a metallic thin layer on the surface of the conductive elastomer layer, forming a resist layer, in which openings have been formed in accordance with the specific pattern, on the surface of the metallic thin layer and subjecting the surfaces of portions exposed through the openings of the resist layer in the metallic thin layer to the plating treatment.

In the process according to the present invention for producing the adaptor device, the conductive elastomer layer may preferably be such that conductive particles exhibiting magnetism are dispersed in an insulating elastic polymeric substance in a state oriented so as to align in the thickness-wise direction.

In such a production process of the adaptor device, the conductive elastomer layer may preferably be formed by forming a material layer for conductive elastomer with the conductive particles exhibiting magnetism contained in a liquid elastomer material, which will become an elastic polymeric substance by being cured, on the releasable supporting plate, applying a magnetic field to the material layer for conductive elastomer in the thickness-wise direction thereof and subjecting the material layer for conductive elastomer to a curing treatment.

According to the present invention, there is provided an adaptor device obtained by the above-described process for producing the adaptor device.

According to the present invention, there is provided an electrical inspection apparatus for circuit device comprising the above-described anisotropically conductive sheet or adaptor device.

### EFFECTS OF THE INVENTION

According to the process of the present invention for producing the anisotropically conductive sheet, the conductive elastomer layer is subjected to the laser beam machining, thereby forming the conductive path-forming parts, so that conductive path-forming parts having the expected conductivity can be surely obtained. Further, since a plurality of the conductive path-forming parts arranged in accordance with the specific pattern are formed, and the material layer for elastomer is then formed between these conductive path-forming parts and subjected to the curing treatment, thereby forming the insulating part, insulating part, in which the conductive particles do not exist at all, can be surely obtained. In addition, it is unnecessary to use a mold used for producing the conventional anisotropically conductive sheet, in which a great number of ferromagnetic substance parts are arranged.

According to the anisotropically conductive sheet of the present invention obtained by such a process, accordingly, necessary electrical connection to respective electrodes to be connected can be surely achieved irrespective of the arrangement pattern of such electrodes, and necessary electrical connection to respective electrodes can be surely achieved even when the electrodes are arranged at a minute pitch and a high density. In addition, such an anisotropically conductive sheet can be produced at low cost.

According to the process of the present invention for producing the adaptor device, the conductive elastomer layer is subjected to the laser beam machining to remove a part thereof, thereby forming the conductive path-forming parts of the intended form, so that an anisotropically conductive sheet, in which the conductive path-forming parts having the expected conductivity have been formed, can be surely obtained.

Further, since a plurality of the conductive path-forming parts arranged in accordance with the specific pattern related to the connecting electrodes of the adaptor body are formed on the releasable supporting plate, and the material layer for elastomer is then formed between these conductive path-forming parts and subjected to the curing treatment, thereby forming the insulating part, an anisotropically conductive sheet that insulating part, in which the conductive particles do not exist at all, is formed can be surely obtained.

In addition, it is unnecessary to use an expensive mold used for producing the conventional anisotropically conductive sheet, in which a great number of ferromagnetic substance parts are arranged.

Further, since the respective conductive path-forming parts are formed integrally with the insulating part, and the whole of these parts is supported on the adaptor body, the conductive path-forming parts are prevented from falling off from the adaptor body.

Since the forming step of the conductive path-forming parts by the laser beam machining is conducted on the releasable supporting plate, the surface of the adaptor body is prevented from being damaged in the formation of the anisotropically conductive sheet.

According to the adaptor device of the present invention obtained by such a process, accordingly, necessary electrical connection to respective electrodes to be inspected of a circuit device, which is an object of inspection, can be surely achieved irrespective of the arrangement pattern of such electrodes to be inspected, and necessary electrical connection to respective electrodes to be inspected can be surely achieved even when the electrodes to be inspected are arranged at a minute pitch and a high density. In addition, the production cost of such an adaptor device can be reduced, and high durability can be achieved.

According to the electrical inspection apparatus for circuit devices of the present invention, necessary electrical inspection on a circuit device, which is an object of inspection, can be surely performed irrespective of the arrangement pattern of electrodes to be inspected of the circuit device, and necessary electrical inspection on a circuit device can be surely performed even when electrodes to be inspected of the circuit device are arranged at a minute pitch and a high density.

### BRIEF DESCRIPTION OF THE DRAWINGS

Fig. 1 is a cross-sectional view illustrating the construction of an exemplary anisotropically conductive sheet according to the present invention.
Fig. 2 is a cross-sectional view illustrating, on an enlarged scale, the construction of a principal part of the anisotropically conductive sheet shown in Fig. 1.
Fig. 3 is a cross-sectional view illustrating a state that a material layer for conductive elastomer has been formed on a releasable supporting plate.
Fig. 4 is a cross-sectional view illustrating, on an enlarged scale, the material layer for conductive elastomer.
Fig. 5 is a cross-sectional view illustrating a state that a magnetic field has been applied to the material layer for conductive elastomer in a thickness-wise direction thereof.
Fig. 6 is a cross-sectional view illustrating a state that a conductive elastomer layer has been formed on the releasable supporting plate.
Fig. 7 is a cross-sectional view illustrating a state that a metallic thin layer has been formed on the conductive elastomer layer.
Fig. 8 is a cross-sectional view illustrating a state that a resist layer having openings has been formed on the metallic thin layer.
Fig. 9 is a cross-sectional view illustrating a state that metal masks have been formed in the openings of the resist layer.
Fig. 10 is a cross-sectional view illustrating a state that a plurality of conductive path-forming parts have been formed in accordance with a specific pattern on the releasable supporting plate.
Fig. 11 is a cross-sectional view illustrating a state that a material layer for insulating part has been formed on a releasable supporting plate.
Fig. 12 is a cross-sectional view illustrating a state that the releasable supporting plate, on which the conductive path-forming part were formed, has been superimposed on the releasable supporting plate, on which the material layer for insulating part was formed.
Fig. 13 is a cross-sectional view illustrating a state that insulating part has been formed between adjacent conductive path-forming parts.
Fig. 14 is a cross-sectional view illustrating the construction of an adaptor device according to a first embodiment of the present invention.
Fig. 15 is a cross-sectional view illustrating the construction of an adaptor body in the adaptor device shown in Fig. 14.
Fig. 16 is a cross-sectional view illustrating, on an enlarged scale, an anisotropically conductive sheet in the adaptor device shown in Fig. 14.
Fig. 17 is a cross-sectional view illustrating a state that a material layer for insulating part has been formed on a front surface of the adaptor body.
Fig. 18 is a cross-sectional view illustrating a state that releasable supporting plate, on which conductive path-forming parts were formed, has been superimposed on the adaptor body, on which the material layer for insulating part was formed.
Fig. 19 is a cross-sectional view illustrating a state that insulating part has formed between adjacent conductive path-forming parts.
Fig. 20 is a cross-sectional view illustrating the construction of an adaptor device according to a second embodiment of the present invention.
Fig. 21 is a cross-sectional view illustrating the construction of an adaptor body in the adaptor device shown in Fig. 20.
Fig. 22 is a cross-sectional view illustrating, on an enlarged scale, an anisotropically conductive sheet in the adaptor device shown in Fig. 20.
Fig. 23 illustrates the construction of an electrical inspection apparatus for circuit devices according to a first embodiment of the present invention.
Fig. 24 illustrates the construction of an electrical inspection apparatus for circuit devices according to a second embodiment of the present invention.
Fig. 25 illustrates a state that conductive path-forming parts have been formed by removing only peripheral portions of portions to become conductive path-forming parts in a conductive elastomer layer.
Fig. 26 is a cross-sectional view illustrating the state that the conductive path-forming parts have been formed by removing only the peripheral portions of the portions to become the conductive path-forming parts in the conductive elastomer layer.
Fig. 27 is a cross-sectional view illustrating a state that a material layer for anisotropically conductive elastomer has been formed on a front surface of an adaptor body in the production of a conventional adaptor device.
Fig. 28 is a cross-sectional view illustrating a state that the adaptor body, on which the material layer for anisotropically conductive elastomer was formed, has been arranged between one template and the other template.
Fig. 29 is a cross-sectional view illustrating a state that an anisotropically conductive sheet has been formed on the front surface of the adaptor body to produce an adaptor device.
Fig. 30 is a cross-sectional view illustrating an arrangement state of connecting electrodes of an adaptor body.
Fig. 31 is a cross-sectional view illustrating directions of a magnetic field applied to a material layer for anisotropically conductive elastomer in the production of a conventional adaptor device.

### [Description of Characters]

- 1a: Adaptor device on an upper side,
- 1b: Adaptor device on a lower side,
- 2: Holder,
- 3: Positioning pin,
- 5: Circuit device,
- 6, 7: Electrodes to be inspected,
- 10: Anisotropically conductive sheet,
- 11: Conductive path-forming parts,
- 11A: Material layer for conductive elastomer,
- 11B: Conductive elastomer layer,
- 12: Insulating part,
- 12A: Material layer for insulating part,
- 15, 15A: Releasable supporting plates,
- 16: Metallic thin layer
- 17: Resist layer,
- 17a: Openings
- 18: Metal masks,
- 20: Adaptor body,
- 21, 21b, 21c: Connecting electrodes,
- 21a: Pairs of connecting electrodes,
- 22: Terminal electrode
- 23: Internal wiring parts,
- 25: Connecting electrode region,
- 50a: Upper-side inspection head,
- 50b: Lower-side inspection head,
- 51a, 51b: Inspection electrode devices,
- 52a, 52b: Inspection electrodes,
- 53a, 53b: Electrical wires,
- 54a, 54b: Supports,
- 55a, 55b: Anisotropically conductive sheets,
- 56a: Upper-side supporting plate,
- 56b: Lower-side supporting plate,
- 57a, 57b: Connectors,
- 80: One template,
- 81, 81a, 81b: Ferromagnetic substance parts,
- 82: Non-magnetic substance parts,
- 83: Electromagnet,
- 85: The other template,
- 86, 86a, 86b: Ferromagnetic substance parts,
- 87: Non-magnetic substance parts,
- 88: Electromagnet,
- 90 ,: Adaptor body
- 91: Connecting electrodes,
- 95: Anisotropically conductive elastomer sheet,
- 95A: Material layer for anisotropically conductive elastomer,
- 96: Conductive path-forming parts,
- 97: Insulating part.

### BEST MODE FOR CARRYING OUT THE INVENTION

The embodiments of the present invention will hereinafter be described in details.

### <Anisotropically conductive sheet>

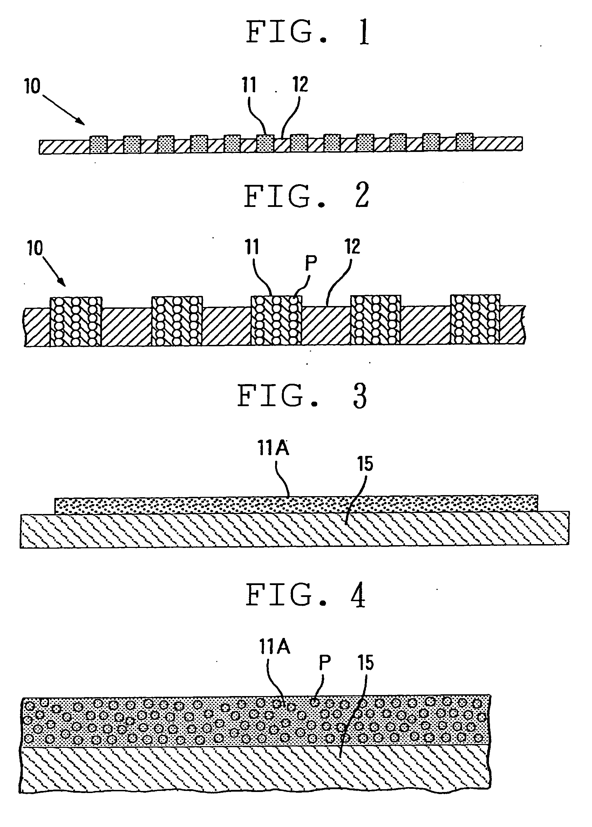

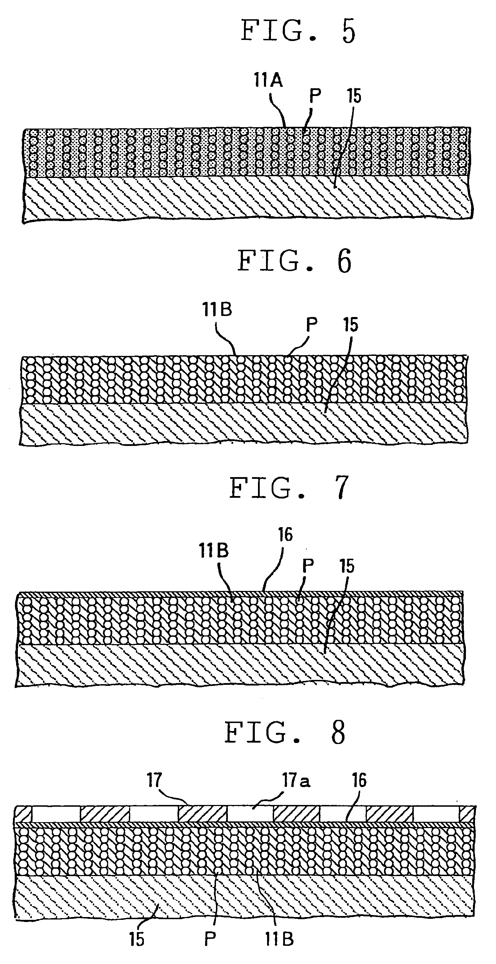

Fig. 1 is a cross-sectional view illustrating the construction of an exemplary anisotropically conductive sheet according to the present invention, and Fig. 2 is a cross-sectional view illustrating, on an enlarged scale, the construction of a principal part of the anisotropically conductive sheet shown in Fig. 1. In this anisotropically conductive sheet 10, a plurality of conductive path-forming parts 11 each extending in a thickness-wise direction of the sheet are arranged in accordance with a specific pattern, and insulating part 12 mutually insulating these conductive path-forming parts is formed between adjacent conductive path-forming parts 11 in a state integrally bonded to the conductive path-forming parts 11. The specific pattern of the conductive path-forming parts 11 is a pattern corresponding to a pattern of electrodes to be connected, for example, electrodes to be inspected of a circuit device that is an object of inspection.

The conductive path-forming parts 11 are formed by causing conductive particles P exhibiting magnetism to be contained in an insulating elastic polymeric substance in a state oriented so as to align in a thickness-wise direction of the sheet. On the other hand, the insulating part 12 is formed by an elastic polymeric substance that does not contain the conductive particles P at all. The elastic polymeric substance forming the conductive path-forming parts 11 and the elastic polymeric substance forming the insulating part 12 may be different from each other or the same.

In the embodiment illustrated, projected parts that the conductive path-forming parts 11 are protruding from the surface of the insulating part 12 are formed on one surface (upper surface in Fig. 1) of the anisotropically conductive sheet 10.

According to such an embodiment, a conductive path sufficiently low in resistance value is surely formed in each conductive path-forming part 11 because the degree of compression by pressurization is greater in the conductive path-forming part 11 than in the insulating part 12, whereby changes in resistance value against changes or variations of pressurizing force can be lessened. As a result, it can be prevented that conductivity varies between the respective conductive path-forming parts 11 even when the pressurizing force applied to the anisotropically conductive sheet 10 is uneven.

The elastic polymeric substances forming the conductive path-forming parts 11 and the insulating part 12 may be the same or different from each other.

The elastic polymeric substances forming the conductive path-forming parts 11 and the insulating part 12 are preferably polymeric substances having a crosslinked structure. As curable polymeric substance-forming materials usable for obtaining such elastic polymeric substances, may be used various materials. Specific examples thereof include conjugated diene rubbers such as polybutadiene rubber, natural rubber, polyisoprene rubber, styrene-butadiene copolymer rubber and acrylonitrile-butadiene copolymer rubber, and hydrogenated products thereof; block copolymer rubbers such as styrene-butadiene-diene block terpolymer rubber and styrene-isoprene block copolymers, and hydrogenated products thereof; chloroprene, urethane rubber, polyester rubber, epichlorohydrin rubber, silicone rubber, ethylene-propylene copolymer rubber and ethylene-propylene-diene terpolymer rubber.

When weather resistance is required in the resulting anisotropically conductive sheet 10 in the embodiment described above, any other material than conjugated diene rubbers is preferably used. In particular, silicone rubber is preferably used from the viewpoints of molding or forming and processing ability and electrical properties.

As the silicone rubber, is preferred that obtained by crosslinking or condensing liquid silicone rubber. The liquid silicone rubber preferably has a viscosity not higher than 10⁵ poises as measured at a shear rate of 10⁻¹ sec and may be any of condensation type, addition type and those having a vinyl group or hydroxyl group. As specific examples thereof, may be mentioned dimethyl silicone raw rubber, methylvinyl silicone raw rubber and methylphenylvinyl silicone raw rubber.

The silicone rubber preferably has a molecular weight Mw (weight average molecular weight as determined in terms of standard polystyrene; the same shall apply hereinafter) of 10,000 to 40,000. It also preferably has a molecular weight distribution index (a ratio Mw/Mn of weight average molecular weight Mw as determined in terms of standard polystyrene to number average molecular weight Mn as determined in terms of standard polystyrene; the same shall apply hereinafter) of at most 2 because good heat resistance is achieved in the resulting conductive path-forming parts 11.

As the conductive particles P contained in the conductive path-forming parts 11, conductive particles exhibiting magnetism are used in that such particles can be easily oriented by a process, which will be described subsequently, so as to align in a thickness-wise direction of the sheet. Specific examples of such conductive particles include particles of metals exhibiting magnetism, such as iron, cobalt and nickel, particles of alloys thereof, particles containing such a metal, particles obtained by using these particles as core particles and plating surfaces of the core particles with a metal having good conductivity, such as gold, silver, palladium or rhodium, and particles obtained by using particles of a non-magnetic metal, particles of an inorganic substance, such as glass beads, or particles of a polymer as core particles and plating surfaces of the core particles with a conductive magnetic metal such as nickel or cobalt.

Among these, particles obtained by using nickel particles as core particles and plating their surfaces with gold having good conductivity are preferably used.

No particular limitation is imposed on a means for coating the surfaces of the core particles with the conductive metal. However, for example, a chemical plating, electroplating, sputtering or vapor deposition process is used.

When those obtained by coating the surfaces of the core particles P with the conductive metal are used as the conductive particles P, the coating rate (proportion of an area coated with the conductive metal to the surface area of the core particles) of the conductive metal on the particle surfaces is preferably at least 40%, more preferably at least 45%, particularly preferably 47 to 95% from the viewpoint of achieving good conductivity.

The amount of the conductive metal to be coated is preferably 0.5 to 50 % by mass, more preferably 2 to 30 % by mass, still more preferably 3 to 25 % by mass, particularly preferably 4 to 20 % by mass based on the core particles. When the conductive metal to be coated is gold, the coating amount thereof is preferably 0.5 to 30 % by mass, more preferably 2 to 20 % by mass, still more preferably 3 to 15 % by mass based on the core particles.

The particle diameter of the conductive particles P is preferably 1 to 100 µm, more preferably 2 to 50 µm, still more preferably 3 to 30 µm, particularly preferably 4 to 20 µm.

The particle diameter distribution (Dw/Dn) of the conductive particles P is preferably 1 to 10, more preferably 1.01 to 7, still more preferably 1.05 to 5, particularly preferably 1.1 to 4.

When conductive particles satisfying such conditions are used, the resulting conductive path-forming parts 11 become easy to deform under pressure, and sufficient electrical contact is achieved among the conductive particles in the conductive path-forming parts 11.

No particular limitation is imposed on the shape of the conductive particles P. However, they are preferably in the shape of a sphere or star, or secondary particles obtained by aggregating these particles from the viewpoint of permitting easy dispersion of these particles in the polymeric substance-forming material.

Those obtained by treating surfaces of the conductive particles with a coupling agent such as a silane coupling agent, or a lubricant may be suitably used as the conductive particles P. By treating the surfaces of the particles with the coupling agent or lubricant, the durability of the resulting anisotropically conductive connector is improved.

Such conductive particles P are preferably contained in a proportion of 15 to 45%, more preferably 20 to 40% in terms of a volume fraction in the conductive path-forming parts 11. If this proportion is too low, conductive path-forming parts 11 sufficiently low in electric resistance value may not be obtained in some cases. If the proportion is too high on the other hand, the resulting conductive path-forming parts 11 are liable to be brittle, so that elasticity required of the conductive path-forming parts 11 may not be achieved in some cases.

In the present invention, the anisotropically conductive sheet 10 is obtained by subjecting a conductive elastomer layer supported on a releasable supporting plate to laser beam machining, thereby forming the conductive path-forming parts 11 arranged in accordance with the specific pattern on the releasable supporting plate, forming a material layer for insulating part composed of a material, which will become an elastic polymeric substance by being cured, between these conductive path-forming parts 11 and subjecting the material layer for insulating part to a curing treatment, thereby forming the insulating part 12.

The conductive elastomer layer is obtained by forming a material layer for conductive elastomer with conductive particles exhibiting magnetism contained in a liquid elastomer material, which will become an elastic polymeric substance by being cured, applying a magnetic field to the material layer for conductive elastomer in a thickness-wise direction thereof and subjecting the material layer for conductive elastomer to a curing treatment.

The production process of the anisotropically conductive sheet 10 will hereinafter be described specifically.

### «Formation of conductive elastomer layer»

A material for conductive elastomer with conductive particles exhibiting magnetism dispersed in a liquid elastomer material, which will become an elastic polymeric substance by being cured, is first prepared, and the material for conductive elastomer is applied on to a releasable supporting plate 15 for formation of conductive path-forming parts, thereby forming a material layer 11A for conductive elastomer as illustrated in Fig. 3. In this embodiment, the conductive particles P exhibiting magnetism are contained in the material layer 11A for conductive elastomer in a dispersed state as illustrated in Fig. 4.

A magnetic field is then applied to the material layer 11A for conductive elastomer in the thickness-wise direction thereof, thereby orienting the conductive particles P dispersed in the material layer 11A for conductive elastomer so as to align in the thickness-wise direction of the material layer 11A for conductive elastomer as illustrated in Fig. 5. The material layer 11A for conductive elastomer is then subjected to a curing treatment while retaining the application of the magnetic field to the material layer 11A for conductive elastomer or after stopping the application of the magnetic field, whereby a conductive elastomer layer 11B with the conductive particles P contained in the elastic polymeric substance in a state oriented so as to align in the thickness-wise direction is formed in a state supported on the releasable supporting plate 15 as illustrated in Fig. 6.

In the above-described process, as a material for forming the releasable supporting plate 15, may be used a metal, ceramic, resin or a composite material thereof.

As a method for applying the material for conductive elastomer, may be used a printing method such as screen printing, roll coating method, blade coating method or the like.

The thickness of the material layer 11A for conductive elastomer is set according to the thickness of conductive path-forming parts to be formed.

As means for applying the magnetic field to the material layer 11A for conductive elastomer, may be used electromagnets, permanent magnets or the like.

The intensity of the magnetic field applied to the material layer 11A for conductive elastomer is preferably an intensity that it amounts to 0.2 to 2.5 T.

The curing treatment of the material layer 11A for conductive elastomer is generally conducted by a heat treatment. Specific heating temperature and heating time are suitably preset in view of the kind of the material for elastomer forming the material layer 11A for conductive elastomer, the time required for movement of the conductive particles, etc.

### «Formation of conductive path-forming parts»

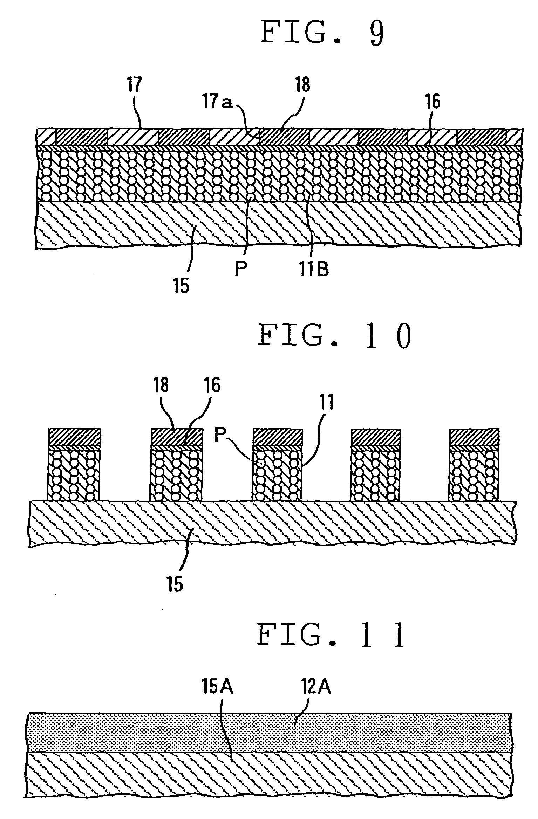

A metallic thin layer 16 for plating electrode is formed on the surface of the conductive elastomer layer 11B supported on the releasable supporting plate 15 as illustrated in Fig. 7. A resist layer 17, in which a plurality of openings 17a have been formed in accordance with a pattern of conductive path-forming parts to be formed, i.e., a specific pattern corresponding to a pattern of electrodes to be connected, is formed on the metallic thin layer 16 by photolithography as illustrated in Fig. 8. Thereafter, the metallic thin layer 16 is used as a plating electrode to subject portions exposed through the openings 17a of the resist layer 17 in the metallic thin layer 16 to an electroplating treatment, thereby forming metal masks 18 within the openings 17a of the resist layer 17 as illustrated in Fig. 9. In this state, the conductive elastomer layer 11B, metallic thin layer 16 and resist layer 17 are subjected to laser beam machining, thereby removing parts of the resist layer 17, metallic thin layer 16 and conductive elastomer layer 11B. As a result, a plurality of conductive path-forming parts 11 arranged in accordance with the specific pattern are formed in a state supported on the releasable supporting plate 15 as illustrated in Fig. 10. Thereafter, the remaining metallic thin layer 16 and metal masks 18 are removed from the surfaces of the conductive path-forming parts 11.

In the above-described process, as a method for forming the metallic thin layer 16 on the surface of the conductive elastomer layer 11B, may be used an electroless plating method, sputtering method or the like.

As a material for forming the metallic thin layer 16, may be used copper, gold, aluminum, rhodium or the like.

The thickness of the metallic thin layer 16 is preferably 0.05 to 2 µm, more preferably 0.1 to 1 µm. If this thickness is too small, no uniform thin layer is formed, and such a thin layer may be unsuitable for use as a plating electrode in some cases. If this thickness is too great on the other hand, it may be difficult in some cases to remove such a metallic thin layer by laser beam machining.

The thickness of the resist layer 17 is preset according to the thickness of the metal masks 18 to be formed.

As a material for forming the metal masks 18, may be used copper, iron, aluminum, gold, rhodium or the like.

The thickness of the metal masks 18 is preferably at least 2 µm, more preferably 5 to 20 µm. If this thickness is too small, such metal masks may be unsuitable for use as masks against laser in some cases.

The laser beam machining is preferably conducted by carbon dioxide gas laser, whereby conductive path-forming parts 11 of the intended form can be surely formed.

### «Formation of insulating part »

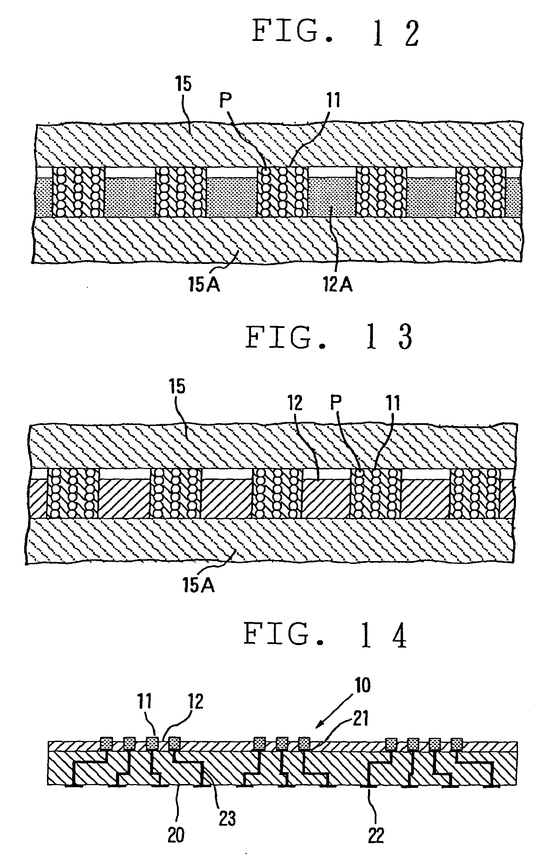

A releasable supporting plate 15A for formation of insulating part is provided as illustrated in Fig. 11, and a liquid elastomer material, which will become an insulating elastic polymeric substance by being cured, is applied on to the surface of this releasable supporting plate 15A, thereby forming a material layer 12A for insulating part. The releasable supporting plate 15, on which the conductive path-forming parts 11 have been formed, is superimposed on the releasable supporting plate 15A, on which the material layer 12A for insulating part has been formed, as illustrated in Fig. 12, thereby bringing each of the conductive path-forming parts 11 into contact with the releasable supporting plate 15A. Material layer 12A for insulating part is thereby formed between adjacent conductive path-forming parts 11. In this state, the material layer 12A for insulating part is then subjected to a curing treatment, whereby insulating part 12 mutually insulating the adjacent conductive path-forming parts 11 is formed integrally with the conductive path-forming parts 11 between them as illustrated in Fig. 13.

The releasable supporting plates 15 and 15A are released, thereby obtaining an anisotropically conductive sheet 10 of the construction shown in Fig. 1.

In the above-described process, as a material for forming the releasable supporting plate 15A, may be used the same material as that for the releasable supporting plate 15 for formation of the conductive path-forming parts.

As a method for applying the material for elastomer, may be used a printing method such as screen printing, roll coating method, blade coating method or the like.

The thickness of the material layer 12A for insulating part is set according to the thickness of insulating part to be formed.

The curing treatment of the material layer 12A for insulating part is generally conducted by a heat treatment. Specific heating temperature and heating time are suitably preset in view of the kind of the elastomer material forming the material layer 12A for insulating part, and the like.

According to the production process described above, the conductive elastomer layer 11A, in which the conductive particles P are dispersed in a state oriented so as to align in the thickness-wise direction, is subjected to the laser beam machining to remove a part thereof, thereby forming the conductive path-forming parts 11 of the intended form, so that conductive path-forming parts 11 charged with a necessary amount of the conductive particles P and having the expected conductivity can be surely obtained.

Further, since a plurality of the conductive path-forming parts 11 arranged in accordance with the specific pattern are formed on the releasable supporting plate 15, and the material layer 12A for insulating part is then formed between these conductive path-forming parts 11 and subjected to the curing treatment, thereby forming the insulating part 12, insulating part 12, in which the conductive particles P do not exist at all, can be surely obtained.

In addition, it is unnecessary to use an expensive mold used for producing the conventional anisotropically conductive sheet, in which a great number of ferromagnetic substance parts are arranged.

According to the anisotropically conductive sheet 10 obtained by such a process, accordingly, necessary electrical connection to respective electrodes can be surely achieved irrespective of the arrangement pattern of such electrodes, and necessary electrical connection to respective electrodes to be connected can be surely achieved even when the electrodes are arranged at a minute pitch and a high density. In addition, the production cost of such an anisotropically conductive sheet can be reduced.

### <Adaptor device>

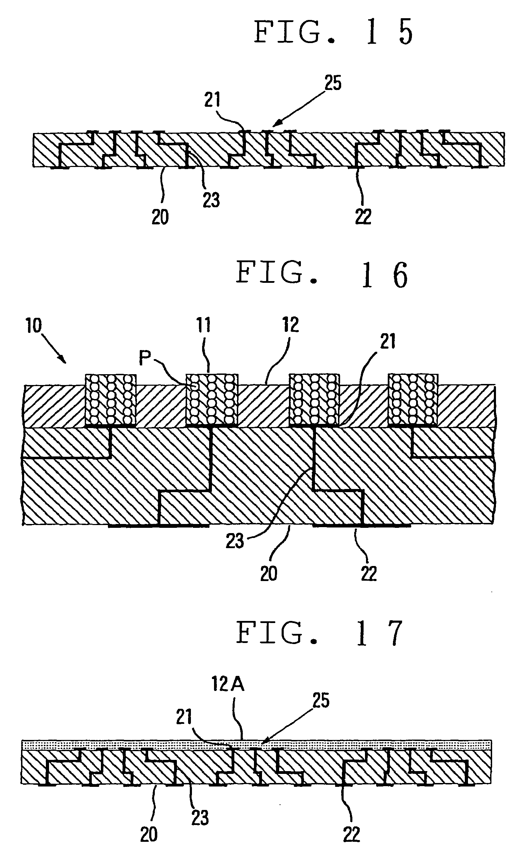

Fig. 14 is a cross-sectional view illustrating the construction of an adaptor device according to a first embodiment of the present invention, and Fig. 15 is a cross-sectional view illustrating an adaptor body in the adaptor device shown in Fig. 14. This adaptor device is used in, for example, an open short-circuit test of, for example, a circuit device such as a printed circuit board and has an adaptor body 20 composed of a multi-layer wiring board.

On a front surface (upper surface in Figs. 14 and 15) of the adaptor body 20, is formed a connecting electrode region 25, in which a plurality of connecting electrodes 21 are arranged in accordance with a specific pattern corresponding to a pattern of electrodes to be inspected of a circuit device that is an object of inspection.

On a back surface of the adaptor body 20, a plurality of terminal electrodes 22 are arranged in accordance with positions of lattice points having a pitch of, for example, 0.8 mm, 0.75 mm, 1.5 mm, 1.8 mm or 2.54 mm, and each of the terminal electrodes 22 is electrically connected to its corresponding connecting electrode 21 through an internal wiring part 23.

An anisotropically conductive sheet 10 is formed on the connecting electrode region 25 at the front surface of the adaptor body 20 in a state integrally bonded or closely contacted. In the embodiment illustrated, the anisotropically conductive sheet 10 is formed so as to cover the whole surface of the adaptor body 20.

This anisotropically conductive sheet 10 is formed by a plurality of conductive path-forming parts 11 arranged in accordance with the same pattern as the specific pattern related to the connecting electrodes 21 in the adaptor body 20 and each extending in a thickness-wise direction of the sheet and insulating part 12 which is formed between adjacent conductive path-forming parts 11 in a state integrally bonded to each of the conductive path-forming parts 11 and mutually insulating these conductive path-forming parts 11. The anisotropically conductive sheet 10 is arranged in such a manner that each of the conductive path-forming parts 11 are located on the respective connecting electrodes 21 of the adaptor body 20.

As illustrated in Fig. 16 on an enlarged scale, each of the conductive path-forming parts 11 is formed by causing conductive particles P exhibiting magnetism to be contained in an insulating elastic polymeric substance in a state oriented so as to align in a thickness-wise direction. On the other hand, the insulating part 12 is formed by an elastic polymeric substance that does not contain the conductive particles P at all. The elastic polymeric substance forming the conductive path-forming parts 11 and the elastic polymeric substance forming the insulating part 12 may be different from each other or the same.

As the elastic polymeric substances forming the conductive path-forming parts 11 and insulating part 12 in the anisotropically conductive sheet 10, and the conductive particles making up the conductive path-forming parts 11, may be used the same as those in the anisotropically conductive sheet 10 shown in Fig. 1.

In the embodiment illustrated, projected parts each protruding from the surface of the insulating part 12 are formed by the conductive path-forming parts 11 at the front surface (upper surface in Fig. 16) of the anisotropically conductive sheet 10.

According to such an embodiment, a conductive path sufficiently low in resistance value is surely formed in each conductive path-forming part 11 because the degree of compression by pressurization is greater in the conductive path-forming part 11 than the insulating part 12, whereby changes in resistance value against changes or variations of pressurizing force can be lessened. As a result, occurrence of variation in conductivity can be prevented between the respective conductive path-forming parts 11 even when the pressurizing force applied to the anisotropically conductive sheet 10 is uneven.

In the present invention, the adaptor device described above is obtained by subjecting a conductive elastomer layer supported on a releasable supporting plate to laser beam machining, thereby forming the conductive path-forming parts 11 arranged in accordance with the specific pattern related to the connecting electrodes 21 of the adaptor body 20 on the releasable supporting plate, superimposing the releasable supporting plate, on which the conductive path-forming parts 11 have been formed, on the adaptor body 20, in which a material layer for insulating part composed of an elastomer material, which will become an insulating elastic polymeric substance by being cured, has been formed on the connecting electrode region 25, thereby bringing each of the connecting electrodes 21 in the connecting electrode region 25 of the adaptor body 20 into contact with its corresponding conductive path-forming part 11, and subjecting the material layer for insulating part to a curing treatment in this state, thereby forming the insulating part 12.

The conductive elastomer layer is also obtained by forming a material layer for conductive elastomer with the conductive particles exhibiting magnetism contained in a liquid elastomer material, which will become an elastic polymeric substance by being cured, on the releasable supporting plate, applying a magnetic field to the material layer for conductive elastomer in the thickness-wise direction thereof and subjecting the material layer for conductive elastomer to a curing treatment.

The production process of the adaptor device will hereinafter be described specifically.

A conductive elastomer layer 11B is first formed on a releasable supporting plate 15 in the same manner as in the production process of the anisotropically conductive sheet 10 shown in Fig. 1. A metallic thin layer 16 is formed on the surface of this conductive elastomer layer 11B, and a resist layer 17 and metal masks 18 are formed on the surface of this metallic thin layer 16. In this state, the conductive elastomer layer 11B, metallic thin layer 16 and resist layer 17 are subjected to laser beam machining, thereby forming a plurality of conductive path-forming parts 11 arranged on the releasable supporting plate 15 in accordance with the specific pattern related to the connecting electrodes 21 of the adaptor body 20 (see Fig. 3 to Fig. 10).

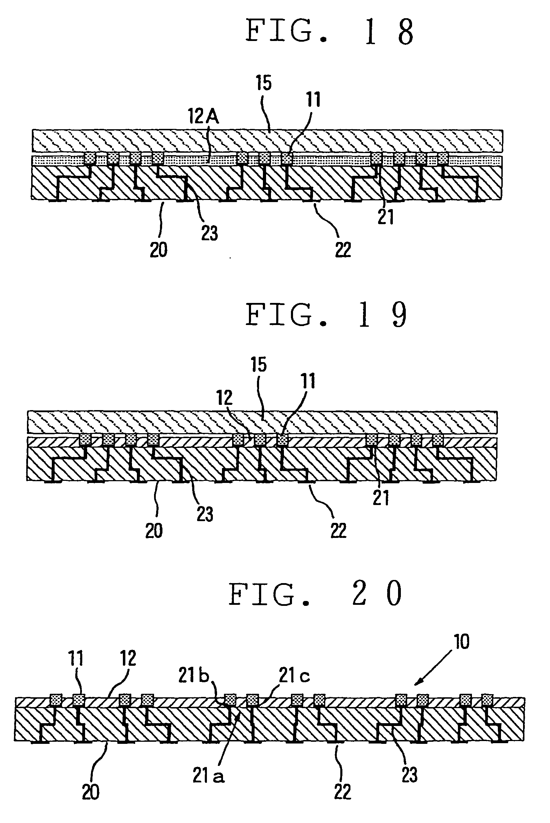

On the other hand, as illustrated in Fig. 17, a liquid elastomer material, which will become an insulating elastic polymeric substance by being cured, is applied on to an front surface of the adaptor body 20, thereby forming a material layer 12A for insulating part. The releasable supporting plate 15, on which a plurality of the conductive path-forming parts 11 have been formed, is then superimposed on the releasable supporting plate 15A, on which the material layer 12A for insulating part has been formed, thereby bringing each of the connecting electrodes 21 in the connecting electrode region 25 of the adaptor body 20 into contact with its corresponding conductive path-forming part 11 as illustrated in Fig. 18. A state that material layer 12A for insulating part has been formed between adjacent conductive path-forming parts 11 is thereby created. In this state, the material layer 12A for insulating part is then subjected to a curing treatment, whereby insulating part 12 mutually insulating the conductive path-forming part 11 is formed integrally with the conductive path-forming parts 11 and adaptor body 20 between adjacent conductive path-forming parts 11 as illustrated in Fig. 19.

The releasable supporting plate 15 is released, thereby obtaining an adaptor device of the construction shown in Fig. 14 that the anisotropically conductive sheet 10 is integrally formed on the surface of the adaptor body 20.

In the above-described process, the adaptor body 20 can be obtained in accordance with an ordinary production process of a multi-layer wiring board.

As a method for applying the material for elastomer, may be used a printing method such as screen printing, roll coating method, blade coating method or the like.

The thickness of the material layer 12A for insulating part is set according to the thickness of insulating part 12 to be formed.

The curing treatment of the material layer 12A for insulating part is generally conducted by a heat treatment. Specific heating temperature and heating time are suitably preset in view of the kind of the elastomer material forming the material layer 12A for insulating part, and the like.

According to the production process described above, the conductive elastomer layer 11A, in which the conductive particles P are dispersed in a state oriented so as to align in the thickness-wise direction, is subjected to the laser beam machining to remove a part thereof, thereby forming the conductive path-forming parts 11 of the intended form, so that the anisotropically conductive sheet 10, in which the conductive path-forming parts 11 charged with a necessary amount of the conductive particles P and having the expected conductivity have been formed, can be surely obtained.

Further, since a plurality of the conductive path-forming parts 11 arranged in accordance with the specific pattern related to the connecting electrodes 21 of the adaptor body 20 are formed on the releasable supporting plate 15, and the material layer 12A for elastomer is then formed between these conductive path-forming parts 11 and subjected to the curing treatment, thereby forming the insulating part 12, the anisotropically conductive sheet 10 that insulating part 12, in which the conductive particles P do not exist at all, is formed can be surely obtained.

In addition, it is unnecessary to use an expensive mold used for producing the conventional anisotropically conductive sheet, in which a great number of ferromagnetic substance parts are arranged.

Further, since the respective conductive path-forming parts 11 are formed integrally with the insulating part 12, and the whole of these parts is supported by the adaptor body 20, the conductive path-forming parts 11 are prevented from falling off from the adaptor body 20.

Since the forming step of the conductive path-forming parts 11 by the laser beam machining is conducted on the releasable supporting plate 15, the surface of the adaptor body 20 is prevented from being damaged in the formation of the anisotropically conductive sheet 10.

According to the adaptor device obtained by such a process, accordingly, necessary electrical connection to respective electrodes to be inspected of a circuit device, which is an object of inspection, can be surely achieved irrespective of the arrangement pattern of such electrodes to be inspected, and necessary electrical connection to respective electrodes to be inspected can be surely achieved even when the electrodes to be inspected are arranged at a minute pitch and a high density. In addition, the production cost can be reduced, and high durability can be achieved.

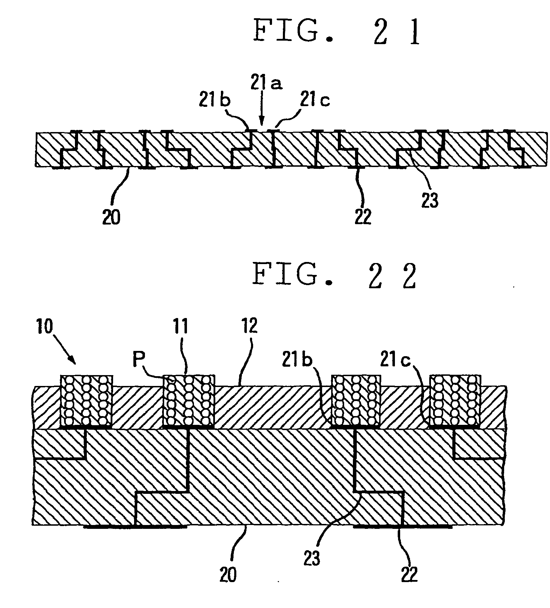

Fig. 20 is a cross-sectional view illustrating the construction of an adaptor device according to a second embodiment of the present invention, and Fig. 21 is a cross-sectional view illustrating an adaptor body in the adaptor device shown in Fig. 20. This adaptor device is used for conducting an electric resistance-measuring test of each wiring pattern as to, for example, a circuit device such as a printed circuit board and has an adaptor body 20 composed of a multi-layer wiring board.

On a front surface (upper surface in Figs. 20 and 21) of the adaptor body 20, is formed a connecting electrode region 25, in which plural pairs 21a of connecting electrodes each composed of a connecting electrode (hereinafter also referred to as "electrode for current supply") 21b for current supply and a connecting electrode (hereinafter also referred to as "electrode for voltage measurement") 21c for voltage measurement electrically connected to the same electrode to be inspected and separated from each other have been arranged. These pairs 21a of connecting electrodes are arranged in accordance with a pattern corresponding to a pattern of electrodes to be inspected in a circuit device that is an object of inspection.

On a back surface of the adaptor body 20, a plurality of terminal electrodes 22 are arranged in accordance with positions of lattice points having a pitch of, for example, 0.8 mm, 0.75 mm, 1.5 mm, 1.8 mm or 2.54 mm.

Each of the electrode 21b for current supply and the electrode 21c for voltage measurement is electrically connected to terminal electrode 22 through an internal wiring part 23.

An anisotropically conductive sheet 10 is formed on the connecting electrode region 25 at the front surface of the adaptor body 20 in a state bonded or closely contacted integrally. In the embodiment illustrated, the anisotropically conductive sheet 10 is formed so as to cover the whole surface of the adaptor body 20.

This anisotropically conductive sheet 10 is formed by a plurality of conductive path-forming parts 11 arranged in accordance with the same pattern as the specific pattern related to the connecting electrodes 21b, 21c in the adaptor body 20 and each extending in a thickness-wise direction of the sheet and insulating part 12 mutually insulating these conductive path-forming parts 11, which is formed between adjacent conductive path-forming parts 11 in a state integrally bonded to respective conductive path-forming parts 11. The anisotropically conductive sheet 10 is arranged in such a manner that the conductive path-forming parts 11 are located on the respective connecting electrodes 21b, 21c of the adaptor body 20. The conductive path-forming parts 11 and insulating part 12 in this anisotropically conductive sheet 10 are basically of the same constructions as those of the anisotropically conductive sheet 10 in the adaptor device according to the first embodiment. More specifically, as illustrated in Fig. 22, each of the conductive path-forming parts 11 is formed by causing conductive particles P exhibiting magnetism to be contained in an insulating elastic polymeric substance in a state oriented so as to align in a thickness-wise direction of the sheet. On the other hand, the insulating part 12 is formed by an elastic polymeric substance that does not contain the conductive particles P at all.

In the present invention, the adaptor device according to the second embodiment can be produced in the same manner as in the adaptor device according to the first embodiment.

More specifically, the adaptor device according to the second embodiment is obtained by subjecting a conductive elastomer layer supported on a releasable supporting plate to laser beam machining, thereby forming the conductive path-forming parts 11 arranged in accordance with the specific pattern related to the connecting electrodes 21b, 21c of the adaptor body 20 on the releasable supporting plate, superimposing the releasable supporting plate, on which the conductive path-forming parts 11 have been formed, on the adaptor body 20, in which a material layer for insulating part composed of an elastomer material, which will become an insulating elastic polymeric substance by being cured, has been formed on the connecting electrode region 25, thereby bringing each of the connecting electrodes 21b, 21c in the connecting electrode region 25 of the adaptor body 20 into contact with its corresponding conductive path-forming part 11, and subjecting the material layer for insulating part to a curing treatment in this state, thereby forming the insulating part 12.

The above conductive elastomer layer is also obtained by forming a material layer for conductive elastomer with the conductive particles exhibiting magnetism contained in a liquid elastomer material, which will become an elastic polymeric substance by being cured, on the releasable supporting plate, applying a magnetic field to the material layer for conductive elastomer in the thickness-wise direction thereof and subjecting the material layer for conductive elastomer to a curing treatment.

According to the production process described above, the conductive elastomer layer, in which the conductive particles P are dispersed in a state oriented so as to align in the thickness-wise direction, is subjected to the laser beam machining to remove a part thereof, thereby forming the conductive path-forming parts 11 of the intended form, so that the anisotropically conductive sheet 10, in which the conductive path-forming parts 11 charged with a necessary amount of the conductive particles P and having the expected conductivity have been formed, can be surely obtained.

Further, since a plurality of the conductive path-forming parts 11 arranged in accordance with the specific pattern related to the connecting electrodes 21b, 21c of the adaptor body 20 are formed on the releasable supporting plate, and the material layer for elastomer is then formed between these conductive path-forming parts 11 and subjected to the curing treatment, thereby forming the insulating part 12, the anisotropically conductive sheet 10 that insulating part 12, in which the conductive particles P do not exist at all, is formed can be surely obtained.

In addition, it is unnecessary to use an expensive mold used for producing the conventional anisotropically conductive sheet, in which a great number of ferromagnetic substance parts are arranged.

Further, since the respective conductive path-forming parts 11 are formed integrally with the insulating part 12, and the whole of these parts is supported by the adaptor body 20, the conductive path-forming parts 11 are prevented from falling off from the adaptor body 20.

Since the forming step of the conductive path-forming parts 11 by the laser beam machining is conducted on the releasable supporting plate, the surface of the adaptor body 20 is prevented from being damaged in the formation of the anisotropically conductive sheet 10.

According to the adaptor device obtained by such a process, accordingly, necessary electrical connection to respective electrodes to be inspected of a circuit device, which is an object of inspection, can be surely achieved irrespective of the arrangement pattern of such electrodes to be inspected, and necessary electrical connection to respective electrodes to be inspected can be surely achieved even when the electrodes to be inspected are arranged at a minute pitch and a high density. In addition, the production cost can be reduced, and high durability can be achieved.

### <Electrical inspection apparatus for circuit device>

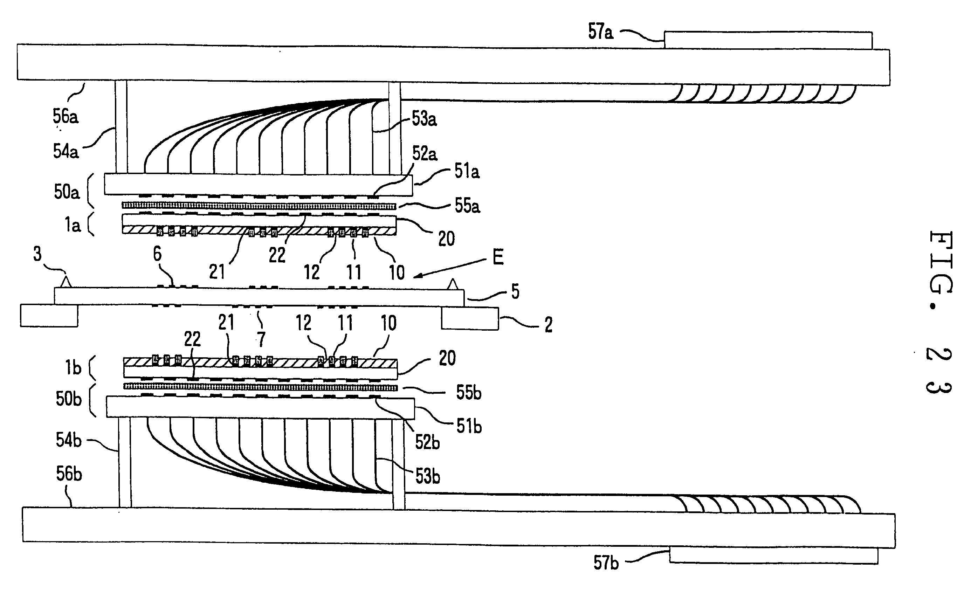

Fig. 23 illustrates the construction of an electrical inspection apparatus according to a first embodiment of the present invention for circuit boards. This electrical inspection apparatus serves to conduct, for example, an open short circuit test as to a circuit device 5 such as a printed circuit board, on both surfaces of which electrodes 6 and 7 to be inspected have been formed, and has a holder 2 for holding the circuit device 5 in an inspection-executing region E. This holder 2 is provided with positioning pins 3 for arranging the circuit device 5 at a proper position in the inspection-executing region E.
Above the inspection-executing region E, an upper-side adaptor device 1a of such construction as shown in Fig. 14 and an upper-side inspection head 50a are arranged in this order, in an ascending scale. Above the upper-side inspection head 50a, an upper-side supporting plate 56a is arranged, and the upper-side inspection head 50a is fixed to the supporting plate 56a by supports 54a. On the other hand, below the inspection-executing region E, a lower-side adaptor device 1b of such construction as shown in Fig. 14 and a lower-side inspection head 50b are arranged in this order, in a descending scale. Below the lower-side inspection head 50b, a lower-side supporting plate 56b is arranged, and the lower-side inspection head 50b is fixed to the supporting plate 56b by supports 54b.

The upper-side inspection head 50a is formed by a plate-like inspection electrode device 51a and an anisotropically conductive sheet 55a having elasticity and arranged by being fixed to a lower surface of the inspection electrode device 51a. The inspection electrode device 51a has, on its lower surface, a plurality of pin-like inspection electrodes 52a arranged at positions of lattice points of the same pitch as terminal electrodes 22 of the upper-side adaptor device 1a. Each of these inspection electrodes 52a is electrically connected to a connector 57a provided on the upper-side supporting plate 56a through an electrical wire 53a and further electrically connected to an inspection circuit (not illustrated) of a tester through the connector 57a.

The lower-side inspection head 50b is formed by a plate-like inspection electrode device 51b and an anisotropically conductive sheet 55b having elasticity and arranged by being fixed to an upper surface of the inspection electrode device 51b. The inspection electrode device 51b has, on its upper surface, a plurality of pin-like inspection electrodes 52b arranged at positions of lattice points of the same pitch as terminal electrodes 22 of the lower-side adaptor device 1b. Each of these inspection electrodes 52b is electrically connected to a connector 57b provided on the lower-side supporting plate 56b through an electrical wire 53b and further electrically connected to the inspection circuit (not illustrated) of the tester through the connector 57b.

The respective anisotropically conductive sheets 55a and 55b in the upper-side inspection head 50a and the lower-side inspection head 50b are such that conductive path-forming parts forming a conductive path in only the thickness-wise direction thereof are formed. As such anisotropically conductive sheets 55a, 55b, it is preferred that each conductive path-forming part is formed so as to protrude in the thickness-wise direction on at least one surface in that high electrical contact stability is exhibited.

In such an electrical inspection apparatus for circuit boards, the circuit device 5, which is the object of inspection, is held in the inspection-executing region E by the holder 2. In this state, the upper-side supporting plate 56a and the lower-side supporting plate 56b are moved in respective directions approaching to the circuit device 5, thereby pinching the circuit device 5 by the upper-side adaptor device 1a and the lower-side adaptor device 1b.

In this state, the electrodes 6 to be inspected on the upper surface of the circuit device 5 are electrically connected to the respective connecting electrodes 21 of the upper-side adaptor device 1a through the conductive path-forming parts 11 of the anisotropically conductive sheet 10, and the terminal electrodes 22 of the upper-side adaptor device 1a are electrically connected to the respective inspection electrodes 52a of the inspection electrode device 51a through the anisotropically conductive sheet 55a. On the other hand, the electrodes 7 to be inspected on the lower surface of the circuit device 5 are electrically connected to the respective connecting electrodes 21 of the lower-side adaptor device 1b through the conductive path-forming parts 11 of the anisotropically conductive sheet 10, and the terminal electrodes 22 of the lower-side adaptor device 1b are electrically connected to the respective inspection electrodes 52b of the inspection electrode device 51b through the anisotropically conductive sheet 55b.

In such a manner, the electrodes 6, 7 to be inspected on both upper and lower surfaces of the circuit device 5 are electrically connected to the inspection electrodes 52a of the inspection electrode device 51a in the upper-side inspection head 50a and the inspection electrodes 52b of the inspection electrode device 51b in the lower-side inspection head 50b, respectively, whereby a state electrically connected to the inspection circuit of the tester is achieved. In this state, necessary electrical inspection is conducted.

According to the electrical inspection apparatus for circuit boards described above, it has the upper-side adaptor device 1a and the lower-side adaptor device 1b of such construction as shown in Fig. 14, so that necessary electrical inspection on a circuit device 5 can be surely performed irrespective of the arrangement pattern of electrodes 6, 7 to be inspected of the circuit device 5, and necessary electrical inspection on a circuit device 5 can be surely performed even when electrodes 6, 7 to be inspected of the circuit device 5 are arranged at a minute pitch and a high density.

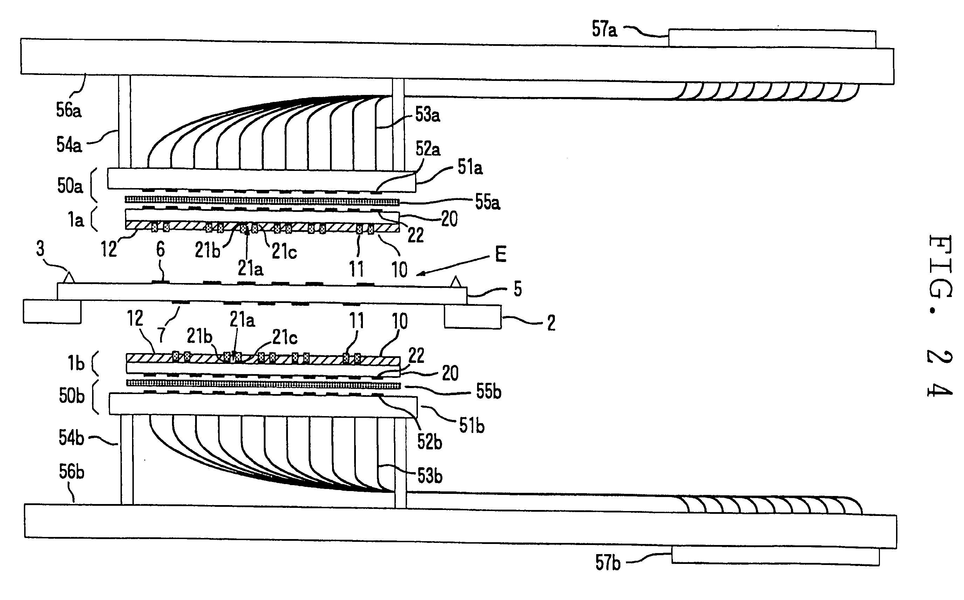

Fig. 24 illustrates the construction of an electrical inspection apparatus according to a second embodiment of the present invention for circuit boards. This electrical inspection apparatus serves to conduct an electric resistance-measuring test of each wiring pattern as to a circuit device 5 such as a printed circuit board, on both surfaces of which electrodes 6 and 7 to be inspected have been formed, and has a holder 2 for holding the circuit device 5 in an inspection-executing region E. This holder 2 is provided with positioning pins 3 for arranging the circuit device 5 at a proper position in the inspection-executing region E.

Above the inspection-executing region E, an upper-side adaptor device 1a of such construction as shown in Fig. 20 and an upper-side inspection head 50a are arranged in this order, in an ascending scale. Above the upper-side inspection head 50a, an upper-side supporting plate 56a is arranged, and the upper-side inspection head 50a is fixed to the supporting plate 56a by supports 54a. On the other hand, below the inspection-executing region E, a lower-side adaptor device 1b of such construction as shown in Fig. 20 and a lower-side inspection head 50b are arranged in this order, in a descending scale. Below the lower-side inspection head 50b, a lower-side supporting plate 56b is arranged, and the lower-side inspection head 50b is fixed to the supporting plate 56b by supports 54b.

The upper-side inspection head 50a is formed by a plate-like inspection electrode device 51a and an anisotropically conductive sheet 55a having elasticity and arranged by being fixed to a lower surface of the inspection electrode device 51a. The inspection electrode device 51a has, on its lower surface, a plurality of pin-like inspection electrodes 52a arranged at positions of lattice points of the same pitch as terminal electrodes 22 of the upper-side adaptor device 1a. Each of these inspection electrodes 52a is electrically connected to a connector 57a provided on the upper-side supporting plate 56a through an electrical wire 53a and further electrically connected to an inspection circuit (not illustrated) of a tester through the connector 57a.

The lower-side inspection head 50b is formed by a plate-like inspection electrode device 51b and an anisotropically conductive sheet 55b having elasticity and arranged by being fixed to an upper surface of the inspection electrode device 51b. The inspection electrode device 51b has, on its upper surface, a plurality of pin-like inspection electrodes 52b arranged at positions of lattice points of the same pitch as terminal electrodes 22 of the lower-side adaptor device 1b. Each of these inspection electrodes 52b is electrically connected to a connector 57b provided on the lower-side supporting plate 56b through an electrical wire 53b and further electrically connected to the inspection circuit (not illustrated) of the tester through the connector 57b.

The respective anisotropically conductive sheets 55a and 55b in the upper-side inspection head 50a and the lower-side inspection head 50b basically have the same construction as in the electrical inspection apparatus according to the first embodiment.

In such an electrical inspection apparatus for circuit boards, the circuit device 5, which is the object of inspection, is held in the inspection-executing region E by the holder 2. In this state, the upper-side supporting plate 56a and the lower-side supporting plate 56b are moved in respective directions approaching to the circuit device 5, thereby pinching the circuit device 5 by the upper-side adaptor device 1a and the lower-side adaptor device 1b.

In this state, each of the electrodes 6 to be inspected on the upper surface of the circuit device 5 is electrically connected to both connecting electrode 21b for current supply and connecting electrode 21c for voltage measurement of the pair 21a of connecting electrodes in the upper-side adaptor device 1a through the conductive path-forming parts 11 of the anisotropically conductive sheet 10, and the terminal electrodes 22 of the upper-side adaptor device 1a are electrically connected to the respective inspection electrodes 52a of the inspection electrode device 51a through the anisotropically conductive sheet 55a. On the other hand, each of the electrodes 7 to be inspected on the lower surface of the circuit device 5 is electrically connected to both connecting electrode 21b for current supply and connecting electrode 21c for voltage measurement of the pair 21a of connecting electrodes in the lower-side adaptor device 1b through the conductive path-forming parts 11 of the anisotropically conductive sheet 10, and the terminal electrodes 22 of the lower-side adaptor device 1b are electrically connected to the respective inspection electrodes 52b of the inspection electrode device 51b through the anisotropically conductive sheet 55b.

In such a manner, the electrodes 6, 7 to be inspected on both upper and lower surfaces of the circuit device 5 are electrically connected to the inspection electrodes 52a of the inspection electrode device 51a in the upper-side inspection head 50a and the inspection electrodes 52b of the inspection electrode device 51b in the lower-side inspection head 50b, respectively, whereby a state electrically connected to the inspection circuit of the tester is achieved. In this state, necessary electrical inspection is conducted. Specifically, a current of a constant value is supplied between the electrode 21b for current supply in the upper-side adaptor device 1a and electrode 21b for current supply in the lower-side adaptor device 1b, and one electrode is designated among the plurality of the electrodes 21c for voltage measurement in the upper-side adaptor device 1a, thereby measuring a voltage between the designated one electrode 21c for voltage measurement and an electrode 21c for voltage measurement in the lower-side adaptor device 1b, which is electrically connected to a lower-side electrode 6 to be inspected corresponding to an upper-side electrode 5 to be inspected electrically connected to the designated electrode 21c for voltage measurement, and gaining an electric resistance value of a wiring pattern formed between the upper-side electrode 5 to be inspected electrically connected to the designated one electrode 21c for voltage measurement and its corresponding other-side electrode 6 to be inspected on the basis of the voltage value thus obtained. Measurement of electric resistances on all wiring patterns is conducted by successively changing an electrode 21c for voltage measurement to be designated.

According to the electrical inspection apparatus for circuit boards described above, it has the upper-side adaptor device 1a and the lower-side adaptor device 1b of such construction as shown in Fig. 20, so that necessary electrical inspection on a circuit device 5 can be surely performed irrespective of the arrangement pattern of electrodes 6, 7 to be inspected of the circuit device 5, and necessary electrical inspection on a circuit device 5 can be surely performed even when electrodes 6, 7 to be inspected of the circuit device 5 are arranged at a minute pitch and a high density.

The present invention is not limited to the above-described embodiments, and various changes or modifications may be added thereto.

For example, in the anisotropically conductive sheet 10, it is not essential to form the projected parts on the conductive path-forming parts 11, and the whole surface of the anisotropically conductive sheet 10 may be flat.

In the adaptor device, the anisotropically conductive sheet 10 may be formed so as to cover only the connecting electrode region 25 of the adaptor body 20.

In the electrical inspection apparatus for circuit devices, an adaptor device formed by the adaptor body and the anisotropically conductive sheet shown in Fig. 1 formed separately from this adaptor body may be used in place of the adaptor device shown in Fig. 14.

The circuit devices that are the objects of inspection are not limited to printed circuit boards, and may be semiconductor integrated circuit devices such as packaged IC and MCM, and circuit devices formed on a wafer.

As the process for forming the conductive elastomer layer 11B supported on the releasable supporting plate 15, may be used a process that a conductive elastomer sheet produced in advance, in which conductive particles exhibiting magnetism are dispersed in an insulating elastic polymeric substance in a state oriented so as to align in a thickness-wise direction of the sheet, is stuck and supported on a releasable supporting plate 15 by the adhesion property of the conductive elastomer sheet or with a proper adhesive. In this process, the conductive elastomer sheet can be produced by forming a material layer for conductive elastomer between, for example, 2 resin sheets, applying a magnetic field to this conductive elastomer layer in a thickness-wise direction thereof to orient conductive particles in the material layer for conductive elastomer so as to align in the thickness-wise direction and subjecting the material layer for conductive elastomer to a curing treatment while retaining the application of the magnetic field or after stopping the application of the magnetic field.

In the formation of the conductive path-forming parts 11, the conductive path-forming parts may be formed by removing all portions other than portions to become conductive path-forming parts in the conductive elastomer layer 11B by the laser beam machining. However, the conductive path-forming parts 11 may also be formed by removing only peripheral portions of portions to become conductive path-forming parts in the conductive elastomer layer 11B as illustrated in Figs. 25 and 26. In this case, the residue of the conductive elastomer layer 11B may be removed by mechanically separating it from the releasable supporting plate 15.

The present invention will hereinafter be described specifically by the following Examples. However, the present invention is not limited to the following Examples.

### <Example 1>

### (1) Production of adaptor body:

An adaptor body (20) of the following specification was produced in accordance with the construction shown in Fig. 15.

More specifically, this adaptor body (20) has dimensions of 40 mm by 80 mm, a material of its base place is a glass fiber-reinforced epoxy resin, connecting electrodes (21) are in the form of a rectangle having dimensions of 50 µm by 100 µm, and 1,024 connecting electrodes in total are arranged at a pitch of 100 µm. Terminal electrodes (22) are in the form of a circle having a diameter of 300 µm, and 1,024 terminal electrodes in total are arranged at a pitch of 500 µm.

### (2) Formation of conductive elastomer layer:

A material for conductive elastomer was prepared by dispersing 400 parts by weight of conductive particles (proportion of gold to core particles: 2 % by weight) obtained by coating core particles composed of nickel with gold in 100 parts by weight of addition type liquid silicone rubber. This material for conductive elastomer was applied to the surface of a releasable supporting plate (15) formed of stainless steel and having a thickness of 5 mm by screen printing, thereby forming a material layer (11A) for conductive elastomer having a thickness of 0.05 mm on the releasable supporting plate (15) (see Figs. 3 and 4).

The material layer (11A) for conductive elastomer was then subjected to a curing treatment under conditions of 120°C for 1 hour while applying a magnetic field of 2 T to the material layer in a thickness-wise direction thereof by electromagnets, thereby forming a conductive elastomer layer (11B) supported on the releasable supporting plate 15 and having a thickness of 0.05 mm (see Figs. 5 and 6).

### (3) Formation of conductive path-forming parts:

The surface of the conductive elastomer layer (11B) supported on the releasable supporting plate (15) was subjected to an electroless plating treatment, thereby forming a metallic thin layer (16) composed of copper and having a thickness of 0.3 µm. On this metallic thin layer (16), a resist layer (17) having a thickness of 25 µm, in which 1,024 rectangular openings (17a) each having dimensions of 50 µm by 100 µm were formed at a pitch of 100 µm, was formed by photolithography. The surface of the metallic thin layer (16) was then subjected to an electroplating treatment, thereby forming metal masks (18) composed of copper and each having a thickness of 20 µm within the openings (17a) of the resist layer (17). In this state, the conductive elastomer layer (11B), metallic thin layer (16) and resist layer (17) were subjected to laser beam machining by means of a carbon dioxide gas laser beam machine, thereby forming 1,024 conductive path-forming parts (11) each supported on the releasable supporting plate (15). Remaining metallic thin layer (16) and metal mask (18) were then separated from each surface of the conductive path-forming parts (11) (see Fig. 10).

In the above-described process, conditions of the laser beam machining by the carbon dioxide gas laser beam machine are as follows.

Namely, the laser beam machining was conducted by using a carbon dioxide gas laser beam machine "ML-605GTX" (manufactured by Mitsubishi Electric Corp.) as the machine and irradiating one machining point with 10 shots of laser beam under conditions that a laser beam diameter was 60 µm, and laser beam output power was 0.8 mJ.

### (4) Formation of insulating part:

Addition type liquid silicone rubber was applied on to a front surface of the adaptor body (20), thereby forming a material layer (12A) for insulating part having a thickness of 0.05 mm, the releasable supporting plate (15), on which the 1,024 conductive path-forming parts (11) had been formed, was superimposed in alignment on the material layer (12A) for insulating part, thereby bringing each of the connecting electrodes (22) of the adaptor body (20) into contact with its corresponding conductive path-forming part (11). A pressure of 20 kgf was then applied to the releasable supporting plate (15), thereby setting the thickness of the material layer (12A) for insulating part to 0.04 mm and elastically compressing the thickness of conductive path-forming parts (11) from 0.05 mm to 0.04 mm. In this state, the material layer (12A) for insulating part was subjected to a curing treatment under conditions of 120°C for 1 hour, thereby forming insulating part (12) between adjacent conductive path-forming parts (11). The releasable supporting plate (15) was then released, thereby producing an adapter device according to the present invention (see Fig. 17 to Fig. 19). The anisotropically conductive sheet in this adaptor device is such that the thickness of each conductive path-forming part (11) is 0.05 mm, the thickness of insulating part (12) is 0.04 mm, the pitch between the conductive path-forming parts (11) is 100 µm, and the projected height of the conductive path-forming part (11) from the insulating part (12) is 0.01 mm.

### <Example 2>

### (1) Production of adaptor body:

An adaptor body (20) of the following specification was produced in accordance with the construction shown in Fig. 15.

More specifically, this adaptor body (20) has dimensions of 40 mm by 80 mm, a material of its base place is a glass fiber-reinforced epoxy resin, connecting electrodes (21) are in the form of a rectangle having dimensions of 50 µm by 100 µm, and 1,024 connecting electrodes in total are arranged at a pitch of 100 µm. Terminal electrodes (22) are in the form of a circle having a diameter of 300 µm, and 1,024 terminal electrodes in total are arranged at a pitch of 500 µm.

### (2) Formation of conductive elastomer layer:

After 25 parts by volume of conductive particles having an average particle diameter of 20 µm were added and mixed into 100 parts by volume of a mixture with Solution A and Solution B of addition type liquid silicone rubber of a two-pack type mixed in proportions that their amounts become equal, the resultant mixture was subjected to a defoaming treatment by pressure reduction, thereby preparing a material for conductive elastomer. In the above-described process, those (average coating amount: 5% by weight of the weight of core particles) obtained by using nickel particles as core particles and subjecting the core particles to electroless plating with gold were used as the conductive particles.

Two polyester resin sheets (product of Toray Industries, Inc.; trade name "Mat Lumirror S10") each having a glossy surface (surface roughness: 0.04 µm) on its front side and a non-glossy surface on its back side and a thickness of 0.1 mm were provided, a frame-like spacer having a thickness of 0.06 mm and a rectangular opening of 120 mm by 200 mm in dimensions was arranged on the front surface of one polyester resin sheet, the material for conductive elastomer prepared above was applied into the opening of this spacer, and the other polyester resin sheet was arranged on this material for conductive elastomer in such a manner that the front surface thereof comes into contact with the material for conductive elastomer. Thereafter, a press rolling machine composed of a press roll and a backup roll was used to pinch the material for conductive elastomer by the two polyester resin sheets, thereby forming a material layer for conductive elastomer having a thickness of 0.06 mm.

The material layer for conductive elastomer was then subjected to a curing treatment under conditions of 120°C for 30 minutes while applying a parallel magnetic field of 0.3 T to the material layer for conductive elastomer in a thickness-wise direction thereof by arranging an electromagnet on the respective back surface of the two polyester resin sheets, thereby producing a rectangular conductive elastomer sheet having a thickness of 0.06 mm. A proportion of the conductive particles in the resultant conductive elastomer sheet was 12% in terms of a volume fraction.

The resultant conductive elastomer sheet was stuck on the surface of a releasable supporting plate (15) formed of stainless steel and having a thickness of 5 mm with a silicone type adhesive, thereby forming a conductive elastomer layer (11B) (see Fig. 5).

### (3) Formation of conductive path-forming parts:

The surface of the conductive elastomer layer (11B) supported on the releasable supporting plate (15) was subjected to an electroless plating treatment, thereby forming a metallic thin layer (16) composed of copper and having a thickness of 0.3 µm. On this metallic thin layer (16), a resist layer (17) having a thickness of 25 µm, in which 1,024 rectangular openings (17a) each having dimensions of 50 µm by 100 µm were formed at a pitch of 100 µm, was formed by photolithography. The surface of the metallic thin layer (16) was then subjected to an electroplating treatment, thereby forming metal masks (18) composed of copper and each having a thickness of 20 µm within the openings (17a) of the resist layer (17). In this state, the conductive elastomer layer (11B), metallic thin layer (16) and resist layer (17) were subjected to laser beam machining by means of a carbon dioxide gas laser beam machine, thereby forming 1,024 conductive path-forming parts (11) each supported on the releasable supporting plate (15). Remaining metallic thin layer (16) and metal mask (18) were then separated from each surface of the conductive path-forming parts (11) (see Fig. 10).

In the above-described process, conditions of the laser beam machining by the carbon dioxide gas laser beam machine are as follows.

Namely, the laser beam machining was conducted by using a carbon dioxide gas laser beam machine "ML-605GTX" (manufactured by Mitsubishi Electric Corp.) as the machine and irradiating one machining point with 10 shots of laser beam under conditions that a laser beam diameter was 60 µm, and laser beam output power was 0.8 mJ.

### (4) Formation of insulating part:

Addition type liquid silicone rubber was applied on to a front surface of the adaptor body (20), thereby forming a material layer (12A) for insulating part having a thickness of 0.05 mm, the releasable supporting plate (15), on which a plurality of conductive path-forming parts (11) had been formed, was superimposed in alignment on the material layer (12A) for insulating part, thereby bringing each of the connecting electrodes (22) of the adaptor body (20) into contact with its corresponding conductive path-forming part (11). A pressure of 1500 kgf was then applied to the releasable supporting plate (15), thereby setting the thickness of the material layer (12A) for insulating part to 0.04 mm and elastically compressing the thickness of conductive path-forming part (11) from 0.06 mm to 0.04 mm. In this state, the material layer (12A) for insulating parts was subjected to a curing treatment under conditions of 120°C for 1 hour, thereby forming insulating part (12) between adjacent conductive path-forming parts (11). The releasable supporting plate (15) was then released, thereby producing an adapter device according to the present invention (see Fig. 17 to Fig. 19). The anisotropically conductive sheet in this adaptor device is such that the thickness of conductive path-forming part (11) is 0.06 mm, the thickness of insulating part (12) is 0.04 mm, the pitch between the conductive path-forming parts (11) is 100 µm, and the projected height of the conductive path-forming part (11) from the insulating part (12) is 0.02 mm.

### <Comparative Example 1>

### (1) Production of adaptor body:

An adaptor body of the following specification was produced in accordance with the construction shown in Fig. 15.

More specifically, this adaptor body has dimensions of 40 mm by 80 mm, a material of its base plate is a glass fiber-reinforced epoxy resin, connecting electrodes are in the form of a rectangle having dimensions of 50 µm by 100 µm, and 1,024 connecting electrodes in total are arranged at a pitch of 100 µm. Terminal electrodes are in the form of a circle having a diameter of 300 µm, and 1,024 terminal electrodes in total are arranged at a pitch of 500 µm.

### (2) Production of mold for forming anisotropically conductive elastomer layer:

A top force and a bottom force of the following specification were produced in accordance with the construction shown in Fig. 28.

Each of ferromagnetic substance parts in the top force has dimensions of 50 µm by 100 µm and a thickness of 100 µm and is made of nickel, and 1,024 ferromagnetic substance parts in total are arranged in accordance with a pattern antipodal to the pattern of the connecting electrodes of the adaptor body. A non-magnetic substance part in the top force has a thickness of 120 µm, a material thereof is a cured product of a dry film resist and formed in a state that the surface thereof is protruded from the ferromagnetic substance part by 20 µm.

Each of ferromagnetic substance parts in the bottom force has dimensions of 50 µm by 100 µm and a thickness of 100 µm and is made of nickel, and 1,024 ferromagnetic substance parts in total are arranged in accordance with the same pattern as the pattern of the connecting electrodes of the adaptor body. A non-magnetic substance part in the bottom force has a thickness of 100 µm and a material thereof is a cured product of a dry film resist.

### (3) Formation of anisotropically conductive sheet:

After 10 parts by volume of conductive particles having an average particle diameter of 20 µm were added and mixed into 100 parts by volume of a mixture with Solution A and Solution B of addition type liquid silicone rubber of a two-pack type mixed in proportions that their amounts become equal, the resultant mixture was subjected to a defoaming treatment by pressure reduction, thereby preparing a material for conductive elastomer. In the above-described process, those (average coating amount: 5% by weight of the weight of core particles) obtained by using nickel particles as core particles and subjecting the core particles to electroless plating with gold were used as the conductive particles. This material for conductive elastomer was applied to the front surface of the adaptor body by screen printing, thereby forming a material layer for conductive elastomer having a thickness of 0.06 mm on the adaptor body.

The adaptor body, on which the material layer for conductive elastomer had been formed, was then arranged in alignment on a front surface of the bottom force, and the top force was arranged in alignment on the surface of the material layer for conductive elastomer formed on the adaptor body. Thereafter, the conductive elastomer layer was subjected to a curing treatment under conditions of 120°C and 1 hour while applying a magnetic field of 2 T between the ferromagnetic substance parts of the top force and ferromagnetic substance parts of the bottom force by arranging a pair of electromagnets on an upper surface of the top force and a lower surface of the bottom force, respectively, and operating the electromagnets, thereby forming an anisotropically conductive sheet integrally provided on the front surface of the adaptor body and composed of 1,024 conductive path-forming parts arranged on the respective connecting electrodes and insulating part intervening between these conductive path-forming parts, thus producing a conductive adaptor device. The anisotropically conductive sheet in this adaptor device was such that the thickness of each conductive path-forming part is 0.06 mm, the thickness of insulating part is 0.04 mm, the pitch between the conductive path-forming parts is 100 µm, the projected height of the conductive path-forming part from the insulating part is 0.02 mm, and the proportion of the conductive particles in the conductive path-forming parts is 16% in terms of a volume fraction.

### <Comparative Example 2>

A comparative adaptor device was produced in the same manner as in Comparative Example 1 except that the amount of the conductive particles used was changed from 10 parts by volume to 15 parts by volume in the preparation of the conductive elastomer material. The anisotropically conductive sheet in this adaptor device was such that the thickness of each conductive path-forming part is 0.06 mm, the thickness of insulating part is 0.04 mm, the pitch between the conductive path-forming parts is 100 µm, the projected height of the conductive path-forming part from the insulating part is 0.02 mm, and the proportion of the conductive particles in the conductive path-forming parts is 21% in terms of a volume fraction.

### <Comparative Example 3>

A comparative adaptor device was produced in the same manner as in Comparative Example 1 except that the amount of the conductive particles used was changed from 10 parts by volume to 20 parts by volume in the preparation of the conductive elastomer material. The anisotropically conductive sheet in this adaptor device was such that the thickness of each conductive path-forming part is 0.06 mm, the thickness of insulating part is 0.04 mm, the pitch between the conductive path-forming parts is 100 µm, the projected height of the conductive path-forming part from the insulating part is 0.02 mm, and the proportion of the conductive particles in the conductive path-forming parts is 25% in terms of a volume fraction.

### <Comparative Example 4>

A comparative adaptor device was produced in the same manner as in Comparative Example 1 except that the amount of the conductive particles used was changed from 10 parts by volume to 25 parts by volume in the preparation of the conductive elastomer material. The anisotropically conductive sheet in this adaptor device was such that the thickness of each conductive path-forming part is 0.06 mm, the thickness of insulating part is 0.04 mm, the pitch between the conductive path-forming parts is 100 µm, the projected height of the conductive path-forming part from the insulating part is 0.02 mm, and the proportion of the conductive particles in the conductive path-forming parts is 28% in terms of a volume fraction.

### [Evaluation of adaptor device]

With respect to the adaptor devices obtained in Examples 1 and 2 and Comparative Examples 1 to 4, an electric resistance (hereinafter referred to as "conduction resistance") between the surface of each of the conductive path-forming parts and a terminal electrode electrically connected to this conductive path-forming part was measured by means of an electric resistance tester in a state that each of the conductive path-forming parts were compressed by 5% in a thickness-wise direction thereof to find a proportion of conductive path-forming parts that the conduction resistance was 0.1 Ω or smaller.

With respect to the adaptor devices obtained in Examples 1 and 2 and Comparative Examples 1 to 4, an electric resistance (hereinafter referred to as "insulation resistance") between 2 conductive path-forming parts (hereinafter referred to as "pair of conductive path-forming parts") adjoining each other was measured by means of an electric resistance tester in'a state that each of the conductive path-forming parts were compressed by 5% in a thickness-wise direction thereof to find a proportion of pairs of conductive path-forming parts that the insulation resistance was 100 MΩ or higher.

The results thereof are shown in Table 1.

**Table 1**

| | proportion of conductive path-forming parts that the conduction resistance was 0.1 Ω or smaller | proportion of pairs of conductive path-forming parts that the insulation resistance was 100 MΩ or higher |
|---|---|---|
| | (%) | (%) |
| Example 1 | 100 | 100 |
| Example 2 | 100 | 100 |
| Comparative Example 1 | 96 | 100 |
| Comparative Example 2 | 98 | 97 |
| Comparative Example 3 | 100 | 93 |
| Comparative Example 4 | 100 | 84 |

As apparent from the results shown in Table 1, it was confirmed that in the adaptor devices obtained in Examples 1 and 2, high conductivity is achieved in all the conductive path-forming parts, and a sufficiently insulated state is achieved between adjacent conductive path-forming parts as to all the conductive path-forming parts.

On the other hand, in the adaptor devices obtained in Comparative Examples 1 to 4, an insulated state between adjacent conductive path-forming parts was not sufficiently achieved as to conductive path-forming parts having high conductivity, while high conductivity was not achieved as to conductive path-forming parts, in which an insulated state between adjacent conductive path-forming parts was sufficiently achieved. Accordingly, no adaptor device, in which all the conductive path-forming parts had high conductivity, and the insulated state between adjacent conductive path-forming parts was sufficiently achieved, was obtained.

## Claims

1. A process for producing an anisotropically conductive sheet formed with a plurality of conductive path-forming parts arranged in accordance with a specific pattern, each extending in a thickness-wise direction of the sheet and mutually insulated by an insulating part, which comprises the steps of
subjecting a conductive elastomer layer supported on a releasable supporting plate to laser beam machining, thereby forming the conductive path-forming parts arranged in accordance with the specific pattern on the releasable supporting plate, forming a material layer for insulating part composed of a material, which will become an elastic polymeric substance by being cured, between the conductive path-forming parts and subjecting the material layer to a curing treatment, thereby forming the insulating part.

2. The process according to claim 1 for producing the anisotropically conductive sheet, wherein the laser beam machining is conducted by carbon dioxide gas laser.

3. The process according to claim 1 or 2 for producing the anisotropically conductive sheet, wherein the conductive path-forming parts arranged in accordance with the specific pattern are formed by forming metal masks on the surface of the conductive elastomer layer in accordance with the specific pattern, and then subjecting the conductive elastomer layer to the laser beam machining.

4. The process according to claim 3 for producing the anisotropically conductive sheet, wherein the metal masks are formed by subjecting the surface of the conductive elastomer layer to a plating treatment.

5. The process according to claim 3 for producing the anisotropically conductive sheet, wherein the metal masks are formed by forming a metallic thin layer on the surface of the conductive elastomer layer, forming a resist layer, in which openings have been formed in accordance with the specific pattern, on the surface of the metallic thin layer and subjecting the surfaces of portions exposed through the openings of the resist layer in the metallic thin layer to the plating treatment.

6. The process according to any one of claims 1 to 5 for producing the anisotropically conductive sheet, wherein the conductive elastomer layer is such that conductive particles exhibiting magnetism are dispersed in an insulating elastic polymeric substance in a state oriented so as to align in the thickness-wise direction.

7. The process according to claim 6 for producing the anisotropically conductive sheet, wherein the conductive elastomer layer is formed by forming a material layer for conductive elastomer with the conductive particles exhibiting magnetism contained in a liquid elastomer material, which will become an elastic polymeric substance by being cured, on the releasable supporting plate, applying a magnetic field to the material layer for conductive elastomer in the thickness-wise direction thereof and subjecting the material layer for conductive elastomer to a curing treatment.

8. An anisotropically conductive sheet obtained by the production process according to any one of claims 1 to 7.

9. A process for producing an adaptor device composed of an adaptor body having, on its front surface, a connecting electrode region, in which a plurality of connecting electrodes have been formed in accordance with a pattern corresponding to electrodes to be inspected in a circuit device to be inspected, and an anisotropically conductive sheet integrally provided on the connecting electrode region of the adaptor body and composed of a plurality of conductive path-forming parts located on the respective surfaces of the connecting electrodes and extending in a thickness-wise direction thereof, and insulating part mutually insulating these conductive path-forming parts, which comprises the steps of
subjecting a conductive elastomer layer, which is supported on a releasable supporting plate and is such that conductive particles exhibiting magnetism are dispersed in an elastic polymeric substance in a state oriented so as to align in the thickness-wise direction, to laser beam machining, thereby forming the conductive path-forming parts arranged in accordance with a specific pattern related to the connecting electrodes of the adaptor body on the releasable supporting plate,
superimposing the releasable supporting plate, on which the conductive path-forming parts have been formed, on the adaptor body, in which a material layer for insulating part composed of a material, which will become an elastic polymeric substance by being cured, has been formed on the connecting electrode region, thereby bringing each of the connecting electrodes in the connecting electrode region of the adaptor body into contact with its corresponding conductive path-forming part, and subjecting the material layer for insulating part to a curing treatment in this state, thereby forming the insulating part.

10. A process for producing an adaptor device composed of an adaptor body having, on its front surface, a connecting electrode region, in which plural pairs of connecting electrodes each composed of 2 connecting electrodes for current supply and for voltage measurement have been formed in accordance with a pattern corresponding to electrodes to be inspected in a circuit device to be inspected, and an anisotropically conductive sheet integrally provided on the connecting electrode region of the adaptor body and composed of a plurality of conductive path-forming parts located on the respective surfaces of the connecting electrodes and extending in a thickness-wise direction thereof, and insulating part mutually insulating these conductive path-forming parts, which comprises the steps of
subjecting a conductive elastomer layer, which is supported on a releasable supporting plate and is such that conductive particles exhibiting magnetism are dispersed in an elastic polymeric substance in a state oriented so as to align in the thickness-wise direction, to laser beam machining, thereby forming the conductive path-forming parts arranged in accordance with a specific pattern related to the connecting electrodes of the adaptor body on the releasable supporting plate,
superimposing the releasable supporting plate, on which the conductive path-forming parts have been formed, on the adaptor body, in which a material layer for insulating part composed of a material, which will become an elastic polymeric substance by being cured, has been formed on the connecting electrode region, thereby bringing each of the connecting electrodes in the connecting electrode region of the adaptor body into contact with its corresponding conductive path-forming part, and subjecting the material layer for insulating part to a curing treatment in this state, thereby forming the insulating part.

11. The process according to claim 9 or 10 for producing the adaptor device, wherein the laser beam machining is conducted by carbon dioxide gas laser.

12. The process according to any one of claims 9 to 11 for producing the adaptor device, wherein the conductive path-forming parts arranged in accordance with the specific pattern are formed by forming metal masks on the surface of the conductive elastomer layer in accordance with the specific pattern, and then subjecting the conductive elastomer layer to the laser beam machining.

13. The process according to claim 12 for producing the adaptor device, wherein the metal masks are formed by subjecting the surface of the conductive elastomer layer to a plating treatment.

14. The process according to claim 12 for producing the adaptor device, wherein the metal masks are formed by forming a metallic thin layer on the surface of the conductive elastomer layer, forming a resist layer, in which openings have been formed in accordance with the specific pattern, on the surface of the metallic thin layer and subjecting the surfaces of portions exposed through the openings of the resist layer in the metallic thin layer to the plating treatment.

15. The process according to any one of claims 9 to 14 for producing the adaptor device, wherein the conductive elastomer layer is such that conductive particles exhibiting magnetism are dispersed in an insulating elastic polymeric substance in a state oriented so as to align in the thickness-wise direction.

16. The process according to claim 15 for producing the adaptor device, wherein the conductive elastomer layer is formed by forming a material layer for conductive elastomer with the conductive particles exhibiting magnetism contained in a liquid elastomer material, which will become an elastic polymeric substance by being cured, on the releasable supporting plate, applying a magnetic field to the material layer for conductive elastomer in the thickness-wise direction thereof and subjecting the material layer for conductive elastomer to a curing treatment.

17. An adaptor device obtained by the production process according to any one of claims 9 to 16.

18. An electrical inspection apparatus for circuit device comprising the anisotropically conductive sheet according to claim 8 or the adaptor device according to claim 17.
